(19)

Europäisches Patentamt
European Patent Office
Office européen des brevets

(11) **EP 4 292 705 A1**

(12) **EUROPEAN PATENT APPLICATION**
published in accordance with Art. 153(4) EPC

(43) Date of publication:
**20.12.2023 Bulletin 2023/51**

(21) Application number: **22752652.2**

(22) Date of filing: **02.02.2022**

(51) International Patent Classification (IPC):
**B01J 27/051** (2006.01)     **B01J 27/049** (2006.01)
**B01J 37/20** (2006.01)      **C01B 3/04** (2006.01)
**C25B 11/075** (2021.01)     **C25B 11/091** (2021.01)
**C30B 29/48** (2006.01)      **H01M 8/0656** (2016.01)

(52) Cooperative Patent Classification (CPC):
**B01J 27/049; B01J 27/051; B01J 37/20;**
**C01B 3/04; C25B 11/075; C25B 11/091;**
**C30B 29/48; H01M 8/0656;** Y02E 60/36

(86) International application number:
**PCT/JP2022/004028**

(87) International publication number:
**WO 2022/172824 (18.08.2022 Gazette 2022/33)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **09.02.2021  JP 2021019047**

(71) Applicant: DIC CORPORATION
**Itabashi-ku**
**Tokyo 174-8520 (JP)**

(72) Inventors:
• KOU, Youki
  **Sakura-shi, Chiba 285-8668 (JP)**
• KANO, Yusuke
  **Sakura-shi, Chiba 285-8668 (JP)**
• TABUCHI, Minoru
  **Sakura-shi, Chiba 285-8668 (JP)**
• YUAN, Jianjun
  **Sakura-shi, Chiba 285-8668 (JP)**

(74) Representative: **TBK**
**Bavariaring 4-6**
**80336 München (DE)**

(54) **HYDROGEN GENERATION CATALYST, AND CATALYST INK**

(57)     A hydrogen generation catalyst according to a first aspect of the present invention contains a molybdenum sulfide powder containing molybdenum disulfide having a 3R crystal structure. A hydrogen generation catalyst according to a second aspect of the present invention contains a metal-doped molybdenum sulfide powder containing a doping metal in Groups 3 to 13 and molybdenum disulfide having a 3R crystal structure.

【Fig. 4】

EP 4 292 705 A1

## Description

Technical Field

The present invention relates to a hydrogen generation catalyst and a catalyst ink.
The present application claims priority based on Japanese Patent Application No. 2021-019047, filed on February 9, 2021, the content of which is incorporated herein.

Background Art

Molybdenum sulfides represented by molybdenum disulfide ($MoS_2$) are well known as, for example, lubricants, steel additives, and molybdate raw materials. These molybdenum sulfides have been used in applications that make effective use of an advantage of being inert.
However, recently, focusing on the activity thereof, attempts have been made to apply the molybdenum sulfides to fine applications such as semiconductor materials and catalysts. Although such activity can be increased to some extent by refining a molybdenum sulfide obtained by any production method such as sulfurization of a molybdenum oxide or by breaking an aggregation of the molybdenum sulfide, in many cases, expected excellent performance cannot be obtained only by the above operations. Therefore, in order to exhibit more excellent performance for each purpose of use, methods for producing a molybdenum sulfide having a peculiar shape such as a single layer shape, a nanoflower shape, or a fullerene shape have been examined (see PTL 1 and PTL 2).
On the other hand, recently, attention has been paid to hydrogen in the fields of renewable energy and fuel cells, and a technique for producing hydrogen becomes increasingly important. Use of hydrogen evolution reaction on an electrode has been examined as a method for producing hydrogen. From the viewpoint of high activity, platinum (Pt) is said to be suitable for an electrode catalyst used in this case. However, platinum is a noble metal and expensive, and the production of platinum is low. Therefore, an electrode catalyst other than platinum has been searched. Molybdenum disulfide has a certain catalytic activity and high stability, and is inexpensive, and therefore molybdenum disulfide is expected as the electrode catalyst used instead of platinum (see NPL 1).

Citation List

Patent Literature

PTL 1: JP-A-2004-277199
PTL 2: JP-T-2004-512250

Non Patent Literature

NPL 1: Chem. Rev., 1 (2016), pp. 699-726

Summary of Invention

Technical Problem

However, the catalytic activity of molybdenum disulfide as an electrode catalyst for a hydrogen evolution reaction is to be improved, and a further improvement in activity as a hydrogen generation catalyst is desired.
It is an object of the present invention to provide a novel hydrogen generation catalyst using molybdenum disulfide.

Solution to Problem

The present invention includes the following aspects.

[1] A hydrogen generation catalyst including a molybdenum sulfide powder containing molybdenum disulfide having a 3R crystal structure.
[2] The hydrogen generation catalyst according to [1], in which the molybdenum sulfide powder contains molybdenum disulfide having a 2H crystal structure and a 3R crystal structure.

[3] The hydrogen generation catalyst according to [2], in which in a spectrum of the molybdenum sulfide powder obtained by powder X-ray diffraction (XRD) using Cu-Kα rays as an X-ray source, both a peak in the vicinity of 39.5° and a peak in the vicinity of 49.5° include a synthetic peak of the 2H crystal structure and the 3R crystal structure, and a half width is 1° or more.

[4] The hydrogen generation catalyst according to any one of [1] to [3], in which primary particles of molybdenum disulfide particles constituting the molybdenum sulfide powder have a string shape, a ribbon shape, or a sheet shape, and have a thickness within a range of 1 nm to 40 nm.

[5] The hydrogen generation catalyst according to any one of [1] to [4], in which the molybdenum sulfide powder has a specific surface area of 10 $m^2$/g or more measured by a BET method.

[6] The hydrogen generation catalyst according to any one of [1] to [5], in which the molybdenum sulfide powder has a median diameter $D_{50}$ of 10 nm to 2,000 nm obtained by a dynamic light scattering type particle diameter distribution measuring device.

[7] The hydrogen generation catalyst according to any one of [1] to [6], in which in a radial distribution function of the molybdenum sulfide powder obtained from an extended X-ray absorption fine structure (EXAFS) spectrum of a K absorption edge of molybdenum, a ratio (I/II) of peak intensity I caused by Mo-S to peak intensity II caused by Mo-Mo is more than 1.0.

[8] A hydrogen generation catalyst including a metal-doped molybdenum sulfide powder containing a doping metal in Groups 3 to 13 and molybdenum disulfide having a 3R crystal structure.

[9] The hydrogen generation catalyst according to [8], in which the metal-doped molybdenum sulfide powder contains molybdenum disulfide having a 2H crystal structure and a 3R crystal structure.

[10] The hydrogen generation catalyst according to [9], in which in a spectrum of the metal-doped molybdenum sulfide powder obtained by powder X-ray diffraction (XRD) using Cu-Kα rays as an X-ray source, both a peak in the vicinity of 39.5° and a peak in the vicinity of 49.5° include a synthetic peak of the 2H crystal structure and the 3R crystal structure, and a half width is 1° or more.

[11] The hydrogen generation catalyst according to any one of [8] to [10], in which primary particles of molybdenum disulfide particles constituting the metal-doped molybdenum sulfide powder have a string shape, a ribbon shape, or a sheet shape, and have a thickness within a range of 1 nm to 40 nm.

[12] The hydrogen generation catalyst according to any one of [8] to [11], in which the metal-doped molybdenum sulfide powder has a specific surface area of 10 $m^2$/g or more measured by a BET method.

[13] The hydrogen generation catalyst according to any one of [8] to [12], in which the metal-doped molybdenum sulfide powder has a median diameter $D_{50}$ of 10 nm to 2,000 nm obtained by a dynamic light scattering type particle diameter distribution measuring device.

[14] The hydrogen generation catalyst according to any one of [8] to [13], in which in a radial distribution function of the metal-doped molybdenum sulfide powder obtained from an extended X-ray absorption fine structure (EXAFS) spectrum of a K absorption edge of molybdenum, a ratio (I/II) of peak intensity I caused by Mo-S to peak intensity II caused by Mo-Mo is more than 1.0.

[15] The hydrogen generation catalyst according to any one of [8] to [14], in which the metal in Groups 3 to 13 is one or two or more selected from the group consisting of cobalt, palladium, iridium, manganese, iron, nickel, zirconium, ruthenium, indium, and zinc.

[16] The hydrogen generation catalyst according to any of [1] to [15], further including a conductive material.

[17] A catalyst ink containing: the hydrogen generation catalyst according to any one of [1] to [16]; and a solvent.

Advantageous Effects of Invention

The present invention provides a novel hydrogen generation catalyst using molybdenum disulfide.

Brief Description of Drawings

FIG. 1 is a schematic view of an example of an apparatus used for producing a molybdenum trioxide powder that is a raw material.

FIG. 2 shows a result of an X-ray diffraction (XRD) pattern of the molybdenum trioxide powder that is a raw material together with a standard pattern (α-MoO3) of an α crystal and a standard pattern (β-MoO3) of a β crystal of molybdenum trioxide.

FIG. 3 shows an extended X-ray absorption fine structure (EXAFS) spectrum of a K absorption edge of molybdenum measured using the molybdenum trioxide powder that is a raw material.

FIG. 4 shows a result of an X-ray diffraction (XRD) pattern of a molybdenum sulfide powder according to Example 1 together with a diffraction pattern of a 3R crystal structure of molybdenum disulfide ($MoS_2$), a diffraction pattern

of a 2H crystal structure of molybdenum disulfide ($MoS_2$), and a diffraction pattern of molybdenum dioxide ($MoO_2$).

FIG. 5 is a TEM image of the molybdenum sulfide powder in Example 1.

FIG. 6 is an AFM image of the metal-doped molybdenum sulfide powder in Example 1.

FIG. 7 is a graph showing a cross-section of the metal-doped molybdenum sulfide powder shown in FIG. 6.

FIG. 8 shows TEM images of a metal-doped molybdenum sulfide powder in Example 3.

FIG. 9 shows SEM images of a metal-doped molybdenum sulfide powder in Example 3.

FIG. 10 shows EDS images of a metal-doped molybdenum sulfide powder in Example 3.

Description of Embodiments

<<Hydrogen Generation Catalyst>>

<First Embodiment>

A hydrogen generation catalyst according to a first embodiment of the present invention contains a molybdenum sulfide powder containing molybdenum disulfide having a 3R crystal structure.

In the hydrogen generation catalyst according to the first embodiment, the molybdenum sulfide powder contains at least molybdenum disulfide having a 3R crystal structure.

For example, the molybdenum sulfide powder may contain molybdenum disulfide having a 2H crystal structure and a 3R crystal structure.

In a spectrum of the molybdenum sulfide powder containing molybdenum disulfide having a 2H crystal structure and a 3R crystal structure in the hydrogen generation catalyst according to the first embodiment, obtained by powder X-ray diffraction (XRD) using Cu-K$\alpha$ rays as an X-ray source, both a peak in the vicinity of 39.5° and a peak in the vicinity of 49.5° include a synthetic peak of the 2H crystal structure and the 3R crystal structure, and a half width may be 1° or more.

The molybdenum sulfide powder in the hydrogen generation catalyst according to the first embodiment may contain molybdenum disulfide having another crystal structure other than the 2H crystal structure and the 3R crystal structure. Examples of such a molybdenum sulfide powder include a molybdenum sulfide powder containing molybdenum disulfide having the 3R crystal structure and the other crystal structure and having no 2H crystal structure; a molybdenum sulfide powder containing molybdenum disulfide having the 2H crystal structure, the 3R crystal structure, and the other crystal structure; and a molybdenum sulfide powder containing molybdenum disulfide having the 2H crystal structure, the 3R crystal structure, and the other crystal structure in which in a spectrum obtained by powder X-ray diffraction (XRD) using Cu-K$\alpha$ rays as an X-ray source, both a peak in the vicinity of 39.5° and a peak in the vicinity of 49.5° include a synthetic peak of the 2H crystal structure and the 3R crystal structure, and a half width is 1° or more.

Examples of the other crystal structure include a 1T crystal structure.

The molybdenum sulfide powder having such a crystal structure and the hydrogen generation catalyst containing the molybdenum sulfide powder are suitable as a catalyst for a hydrogen evolution reaction (HER).

Since molybdenum sulfide particles constituting the molybdenum sulfide powder in the first embodiment have a 3R crystal structure which is a metastable structure, the molybdenum sulfide particles are excellent in activity of the hydrogen generation catalyst. Molybdenum sulfide particles constituting a commercially available molybdenum disulfide powder contain molybdenum sulfide having the 2H crystal structure. On the contrary, the molybdenum sulfide particles constituting the molybdenum sulfide powder in the first embodiment have the 3R crystal structure that is a metastable structure, which can be distinguished by the fact that, in the spectrum obtained by the powder X-ray diffraction (XRD) using the Cu-K$\alpha$ rays as the X-ray source, there are a peak in the vicinity of 39.5° and a peak in the vicinity of 49.5°. The molybdenum sulfide particles have the 2H crystal structure and the 3R crystal structure, which can be distinguished by the fact that, in the spectrum obtained by the same powder X-ray diffraction (XRD) as described above, both the peak in the vicinity of 39.5° and the peak in the vicinity of 49.5° include a synthetic peak of the 2H crystal structure and the 3R crystal structure.

Primary particles of a molybdenum sulfide (molybdenum sulfide particles) in a two-dimensional image when the molybdenum sulfide particles constituting the molybdenum sulfide powder are photographed with a transmission electron microscopy (TEM) may have a particle shape, a spherical shape, a plate shape, a needle shape, a string shape, a ribbon shape, or a sheet shape by visual observation or an image photograph, or may have a combination of these shapes. The primary particles of the molybdenum sulfide (molybdenum sulfide particles) preferably have a string shape, a ribbon shape, or a sheet shape. The shape of 50 primary particles of the molybdenum sulfide preferably has a size in the range of length (vertical) $\times$ width (horizontal) = 50 nm to 2,000 nm $\times$ 50 nm to 2,000 nm on average, more preferably a size in the range of 100 nm to 1,000 nm $\times$ 100 nm to 1,000 nm, and particularly preferably a size in the range of 150 nm to 500 nm $\times$ 150 nm to 500 nm. The shape of the primary particles of the molybdenum sulfide preferably has a thickness, which is measured with an atomic force microscope (AFM), of 1 nm to 40 nm, more preferably 3 nm to 20 nm, and particularly preferably 5 nm to 10 nm. Here, the sheet shape means a thin layer shape. Further, the ribbon shape means a long thin layer shape. When the molybdenum sulfide has a sheet shape, the specific surface area of the molybdenum sulfide powder can be increased, and a catalytic activity for a hydrogen evolution reaction (HER) is more excellent.

The specific surface area of the molybdenum sulfide powder, which is measured by a BET method, is preferably $10 \, m^2/g$ or more, more preferably $30 \, m^2/g$ or more, and particularly preferably $40 \, m^2/g$ or more. As the specific surface area of the molybdenum sulfide powder is larger, the catalytic activities of the molybdenum sulfide powder and the hydrogen generation catalyst containing the molybdenum sulfide powder in the hydrogen evolution reaction (HER) are higher.

The specific surface area of the molybdenum sulfide powder, which is measured by the BET method, may be $300 \, m^2/g$ or less, $200 \, m^2/g$ or less, or $100 \, m^2/g$ or less.

The median diameter $D_{50}$ of the molybdenum sulfide powder (the molybdenum sulfide particles constituting the molybdenum sulfide powder), which is obtained by a dynamic light scattering type particle diameter distribution measuring device, is preferably 10 nm to 2,000 nm. Since the molybdenum sulfide powder is produced from molybdenum trioxide ($MoO_3$) having a large surface area and more favorable reactivity with sulfur, the median diameter $D_{50}$ of the molybdenum sulfide powder is preferably 2,000 nm or less, more preferably 1,500 nm or less, and particularly preferably 1,000 nm or less. The median diameter $D_{50}$ of the molybdenum sulfide powder may be 10 nm or more, 20 nm or more, or 40 nm or more.

In a radial distribution function of the molybdenum sulfide powder, which is obtained from an extended X-ray absorption fine structure (EXAFS) spectrum of a K absorption edge of molybdenum, a ratio (I/II) of peak intensity I caused by Mo-S to peak intensity II caused by Mo-Mo is preferably more than 1.0, more preferably 1.1 or more, and particularly preferably 1.2 or more.

A conversion rate $R_C$ to $MoS_2$ of the molybdenum sulfide powder is preferably 70% or more, more preferably 80% or more, and particularly preferably 90% or more. When the conversion rate $R_C$ to $MoS_2$ of the molybdenum sulfide powder is high, catalytic activities of the molybdenum sulfide powder and the hydrogen generation catalyst containing the molybdenum sulfide powder in a hydrogen evolution reaction (HER) are high.

The conversion rate $R_C$ to $MoS_2$ of the molybdenum sulfide powder can be obtained by a reference intensity ratio (RIR) method based on spectral data obtained by measuring the molybdenum sulfide powder with the X-ray diffraction (XRD). The conversion rate $R_C$ to $MoS_2$ can be obtained according to the following equation (1) using an RIR value $K_A$ of molybdenum sulfide ($MoS_2$), integrated intensity $I_A$ of a peak in the vicinity of $2\theta = 14.4° \pm 0.5°$ attributed to the plane (002) or the plane (003) of molybdenum sulfide ($MoS_2$), an RIR value $K_B$ of each molybdenum oxide ($MoO_3$ as a raw material, and $Mo_9O_{25}$, $Mo_4O_{11}$, $MoO_2$, etc. as reaction intermediates), and integrated intensity $I_B$ of the strongest line peak of each molybdenum oxide ($MoO_3$ as a raw material, and $Mo_9O_{25}$, $Mo_4O_{11}$, $MoO_2$, etc. as reaction intermediates).

$$R_C \, (\%) = (I_A/K_A)/(\Sigma(I_B/K_B)) \times 100 \quad (1)$$

Here, values described in the ICSD database can be used as the RIR values, and integrated X-ray powder diffraction software (PDXL) (Rigaku Corporation) can be used for analysis.

The hydrogen generation catalyst according to the first embodiment may further contain a conductive material in addition to the molybdenum sulfide powder. The catalytic activity of the hydrogen generation catalyst containing the molybdenum sulfide powder and the conductive material in the hydrogen evolution reaction (HER) is higher.

The conductive material may be a publicly known conductive material.

Examples of the conductive material include carbon and a metal that have high conductivity.

The hydrogen generation catalyst according to the first embodiment may contain only one type of the conductive material or two or more types thereof.

Examples of the carbon include acetylene black, Cabot carbon black, and ketjen black.

The hydrogen generation catalyst according to the first embodiment may contain only one type of the carbon or two or more types thereof.

The carbon is preferably one or two or more selected from the group consisting of acetylene black, Cabot carbon black, and ketjen black, more preferably ketjen black, and further preferably one or two or more selected from the group consisting of ketjen black EC300J and ketjen black EC600JD. Ketjen black has a high specific surface area and conductivity, and is excellent from the viewpoint of suppressing aggregation of molybdenum sulfide.

Examples of the metal that is the conductive material include gold, silver, copper, aluminum, rhodium, molybdenum, tungsten, iron, nickel, cobalt, and indium.

The metal that is the conductive material is merely mixed with the molybdenum sulfide powder in the hydrogen generation catalyst according to the first embodiment, and is not added for doping to the molybdenum sulfide powder.

The hydrogen generation catalyst according to the first embodiment may contain only one type of the metal that is the conductive material or two or more types thereof.

As the conductive material, for example, the hydrogen generation catalyst according to the first embodiment may contain the carbon and no metal, may contain the metal and no carbon, or may contain both the metal and the carbon.

The content of the conductive material in the hydrogen generation catalyst according to the first embodiment is preferably 1 mass% to 50 mass%, more preferably 5 mass% to 40 mass%, and further preferably 10 mass% to 30 mass%, with respect to the content of the molybdenum sulfide powder. When the content falls within such a range, an effect of improving the activity of the hydrogen generation catalyst according to the first embodiment is higher.

A ratio of the total content (part by mass) of the molybdenum sulfide powder and the conductive material in the hydrogen generation catalyst according to the first embodiment to the whole mass of the hydrogen generation catalyst is preferably 80 mass% or more, more preferably 90 mass% or more, and further preferably 95 mass% or more, and may be, for example, any of 97 mass% or more and 99 mass% or more, or 100 mass%. When the ratio is equal to or more than the lower limit value, the catalytic activity of the hydrogen generation catalyst in the hydrogen evolution reaction (HER) is higher. The ratio is 100 mass% or less.

<Second Embodiment>

A hydrogen generation catalyst according to a second embodiment contains a metal-doped molybdenum sulfide powder containing a doping metal in Groups 3 to 13 and molybdenum disulfide having a 3R crystal structure. Herein, the "metal-doped molybdenum sulfide powder" is synonymous with a "powder of molybdenum disulfide doped with a metal in Groups 3 to 13" or a "powder of molybdenum disulfide containing a metal as a dopant". Herein, a simple description of "molybdenum sulfide powder" means a molybdenum sulfide powder not doped with a metal in Groups 3 to 13 (for example, the molybdenum sulfide powder containing the hydrogen generation catalyst according to the first embodiment), and does not mean "metal-doped molybdenum sulfide powder".

The hydrogen generation catalyst according to the second embodiment is the same as the hydrogen generation catalyst according to the first embodiment described above except that the metal-doped molybdenum sulfide powder is contained instead of the molybdenum sulfide powder.

In the hydrogen generation catalyst according to the second embodiment, the metal-doped molybdenum sulfide powder contains at least molybdenum disulfide having a 3R crystal structure.

For example, the metal-doped molybdenum sulfide powder may contain molybdenum disulfide having a 2H crystal structure and a 3R crystal structure.

In a spectrum of the metal-doped molybdenum sulfide powder containing molybdenum disulfide having a 2H crystal structure and a 3R crystal structure in the hydrogen generation catalyst according to the second embodiment, obtained by powder X-ray diffraction (XRD) using Cu-K$\alpha$ rays as an X-ray source, both a peak in the vicinity of 39.5° and a peak in the vicinity of 49.5° include a synthetic peak of the 2H crystal structure and the 3R crystal structure, and a half width may be 1° or more.

The metal-doped molybdenum sulfide powder in the hydrogen generation catalyst according to the second embodiment may contain molybdenum disulfide having another crystal structure other than the 2H crystal structure and the 3R crystal structure. Examples of such a metal-doped molybdenum sulfide powder include a metal-doped molybdenum sulfide powder containing molybdenum disulfide having the 3R crystal structure and the other crystal structure and having no 2H crystal structure; a metal-doped molybdenum sulfide powder containing molybdenum disulfide having the 2H crystal structure, the 3R crystal structure, and the other crystal structure; and a metal-doped molybdenum sulfide powder containing molybdenum disulfide having the 2H crystal structure, the 3R crystal structure, and the other crystal structure in which in a spectrum obtained by powder X-ray diffraction (XRD) using Cu-K$\alpha$ rays as an X-ray source, both a peak in the vicinity of 39.5° and a peak in the vicinity of 49.5° include a synthetic peak of the 2H crystal structure and the 3R crystal structure, and a half width is 1° or more.

Examples of the other crystal structure include a 1T crystal structure.

The metal-doped molybdenum sulfide powder having such a crystal structure and the hydrogen generation catalyst containing the metal-doped molybdenum sulfide powder are suitable as a catalyst for a hydrogen evolution reaction (HER).

Since metal-doped molybdenum sulfide particles constituting the metal-doped molybdenum sulfide powder in the second embodiment have a 3R crystal structure that is a metastable structure, the metal-doped molybdenum sulfide particles are excellent in activity of the hydrogen generation catalyst. The metal-doped molybdenum sulfide particles in the second embodiment have the 3R crystal structure that is a metastable structure, which can be distinguished by the fact that, in the spectrum obtained by the powder X-ray diffraction (XRD) using the Cu-K$\alpha$ rays as the X-ray source, there are a peak in the vicinity of 39.5° and a peak in the vicinity of 49.5°. The metal-doped molybdenum sulfide particles have the 2H crystal structure and the 3R crystal structure, which can be distinguished by the fact that, in the spectrum obtained by the same powder X-ray diffraction (XRD) as described above, both the peak in the vicinity of 39.5° and the peak in the vicinity of 49.5° include a synthetic peak of the 2H crystal structure and the 3R crystal structure.

Primary particles of a metal-doped molybdenum sulfide (metal-doped molybdenum sulfide particles) in a two-dimensional image when the metal-doped molybdenum sulfide particles constituting the metal-doped molybdenum sulfide powder are photographed with a transmission electron microscopy (TEM) may have a particle shape, a spherical shape, a plate shape, a needle shape, a string shape, a ribbon shape, or a sheet shape by visual observation or an image photograph, or may have a combination of these shapes. The primary particles of the metal-doped molybdenum sulfide (metal-doped molybdenum sulfide particles) preferably have a string shape, a ribbon shape, or a sheet shape. The shape of 50 primary particles of the metal-doped molybdenum sulfide preferably has a size in the range of length (vertical) × width (horizontal) = 50 nm to 2,000 nm × 50 nm to 2,000 nm on average, more preferably a size in the range of 100 nm to 1,000 nm × 100 nm to 1,000 nm, and particularly preferably a size in the range of 150 nm to 500 nm × 150 nm to 500 nm. The shape of the primary particles of the metal-doped molybdenum sulfide preferably has a thickness, which is measured with an atomic force microscope (AFM), of 1 nm to 40 nm, more preferably 3 nm to 20 nm, and particularly preferably 5 nm to 10 nm. Here, the sheet shape means a thin layer shape. Further, the ribbon shape means a long thin layer shape. When the metal-doped molybdenum sulfide has a sheet shape, the specific surface area of the metal-doped molybdenum sulfide powder can be increased, and the catalytic activity for a hydrogen evolution reaction (HER) is more excellent.

The specific surface area of the metal-doped molybdenum sulfide powder, which is measured by a BET method, is preferably 10 $m^2/g$ or more, more preferably 30 $m^2/g$ or more, and particularly preferably 40 $m^2/g$ or more. As the specific surface area of the metal-doped molybdenum sulfide powder is larger, the catalytic activities of the metal-doped molybdenum sulfide powder and the hydrogen generation catalyst containing the metal-doped molybdenum sulfide powder in the hydrogen evolution reaction (HER) are higher.

The specific surface area of the metal-doped molybdenum sulfide powder, which is measured by the BET method, may be 300 $m^2/g$ or less, 200 $m^2/g$ or less, or 100 $m^2/g$ or less.

The median diameter $D_{50}$ of the metal-doped molybdenum sulfide powder (the metal-doped molybdenum sulfide particles constituting the metal-doped molybdenum sulfide powder), which is obtained by a dynamic light scattering type particle diameter distribution measuring device, is preferably 10 nm to 2,000 nm. Since the metal-doped molybdenum sulfide powder is produced from molybdenum trioxide (MoOs) having a large surface area and more favorable reactivity with sulfur, the median diameter $D_{50}$ of the metal-doped molybdenum sulfide powder is preferably 600 nm or less, more preferably 500 nm or less, and particularly preferably 400 nm or less. The median diameter $D_{50}$ of the metal-doped molybdenum sulfide particles may be 10 nm or more, 20 nm or more, or 40 nm or more.

In a radial distribution function of the metal-doped molybdenum sulfide powder, which is obtained from an extended X-ray absorption fine structure (EXAFS) spectrum of a K absorption edge of molybdenum, a ratio (I/II) of peak intensity I caused by Mo-S to peak intensity II caused by Mo-Mo is preferably 0.1 or more, more preferably 0.5 or more, and particularly preferably 1.0 or more.

A conversion rate $R_C$ to $MoS_2$ of the metal-doped molybdenum sulfide powder is preferably 70% or more, more preferably 80% or more, and particularly preferably 90% or more. When the conversion rate $R_C$ to $MoS_2$ of the metal-doped molybdenum sulfide powder is high, catalytic activities of the metal-doped molybdenum sulfide powder and the hydrogen generation catalyst containing the metal-doped molybdenum sulfide powder in a hydrogen evolution reaction (HER) are high.

The conversion rate $R_C$ to $MoS_2$ of the metal-doped molybdenum sulfide powder can be obtained in the same manner as in the case of the conversion rate $R_C$ to $MoS_2$ of the molybdenum sulfide powder except that a target of X-ray diffraction (XRD) is the metal-doped molybdenum sulfide powder, but not the molybdenum sulfide powder.

The metal in Groups 3 to 13 is not particularly limited as long as it is a metal belonging to any of Group 3, Group 13, and a group between Groups 3 and 13 of the periodic table.

Specific examples of the metal in Groups 3 to 13 include a metal in Group 3, such as scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), actinium (Ac), thorium (Th), protactinium (Pa), uranium (U), neptunium (Np), plutonium (Pu), americium (Am), curium (Cm), berkelium (Bk), californium (Cf), einsteinium (Es), fermium (Fm), mendelevium (Md), nobelium (No), and lawrencium (Lr);

a metal in Group 4, such as titanium (Ti), zirconium (Zr), hafnium (Hf), and rutherfordium (Rf);
a metal in Group 5, such as vanadium (V), niobium (Nb), tantalum (Ta), and dubnium (Db);
a metal in Group 6, such as chromium (Cr), molybdenum (Mo), tungsten (W), and seaborgium (Sg);
a metal in Group 7, such as manganese (Mn), technetium (Tc), rhenium (Re), and bohrium (Bh);
a metal in Group 8, such as iron (Fe), ruthenium (Ru), osmium (Os), and hassium (Hs);
a metal in Group 9, such as cobalt (Co), rhodium (Rh), iridium (Ir), and meitnerium (Mt);
a metal in Group 10, such as nickel (Ni), palladium (Pd), platinum (Pt), and darmstadtium (Ds);
a metal in Group 11, such as copper (Cu), silver (Ag), gold (Au), and roentgenium (Rg);

a metal in Group 12, such as zinc (Zn), cadmium (Cd), mercury (Hg), and copernicium (Cn); and

a metal in Group 13, such as boron (B), aluminum (Al), gallium (Ga), indium (In), thallium (Tl), and nihonium (Nh).

The metal-doped molybdenum sulfide powder may contain only one type of the doping metal in Groups 3 to 13 or two or more types thereof.

The metal in Groups 3 to 13 is preferably one or two or more selected from the group consisting of cobalt, palladium, iridium, manganese, iron, nickel, zirconium, ruthenium, indium, and zinc.

A ratio (herein also referred to as "metal doping amount") of the amount (molar amount) of the metal in Groups 3 to 13 to the amount (molar amount) of molybdenum in the metal-doped molybdenum sulfide powder is preferably 0.01 mol% to 30 mol%, more preferably 0.1 mol% to 20 mol%, and further preferably 0.2 mol% to 10 mol%. When the ratio falls within such a range, the catalytic activities of the metal-doped molybdenum sulfide powder and the hydrogen generation catalyst containing the metal-doped molybdenum sulfide powder in the hydrogen evolution reaction (HER) are higher.

The hydrogen generation catalyst according to the second embodiment may further contain a conductive material in addition to the metal-doped molybdenum sulfide powder. The catalytic activities of the hydrogen generation catalyst containing the metal-doped molybdenum sulfide powder and the conductive material in the hydrogen evolution reaction (HER) are higher.

Examples of the conductive material include those exemplified as the conductive material contained in the hydrogen generation catalyst according to the first embodiment described above (for example, carbon and a metal that have high conductivity).

For example, the metal that is the conductive material is merely mixed with the metal-doped molybdenum sulfide powder in the hydrogen generation catalyst according to the second embodiment, unlike the doping metal contained in the metal-doped molybdenum sulfide powder.

The hydrogen generation catalyst according to the second embodiment may contain only one type of the conductive material or two or more types thereof.

As the conductive material, for example, the hydrogen generation catalyst according to the second embodiment may contain the carbon and no metal, may contain the metal and no carbon, or may contain both the metal and the carbon.

The content of the conductive material in the hydrogen generation catalyst according to the second embodiment is preferably 1 mass% to 50 mass%, more preferably 2 mass% to 30 mass%, and further preferably 3 mass% to 15 mass%, with respect to the content of the metal-doped molybdenum sulfide powder. When the content falls within such a range, an effect of improving the activity of the hydrogen generation catalyst according to the second embodiment is higher.

A ratio of the total content (part by mass) of the metal-doped molybdenum sulfide powder and the conductive material in the hydrogen generation catalyst according to the second embodiment to the whole mass of the hydrogen generation catalyst is preferably 80 mass% or more, more preferably 90 mass% or more, and further preferably 95 mass% or more, and may be, for example, any of 97 mass% or more and 99 mass% or more, or 100 mass%. When the ratio is equal to or more than the lower limit value, the catalytic activities of the metal-doped molybdenum sulfide powder and the hydrogen generation catalyst containing the metal-doped molybdenum sulfide powder in the hydrogen evolution reaction (HER) are higher. The ratio is 100 mass% or less.

<<Method for Producing Metal-Doped Molybdenum Sulfide Powder>>

The metal-doped molybdenum sulfide powder can be produced, for example, by a production method (herein also referred to as "production method (1)") including dry-mixing a molybdenum trioxide powder made of an aggregate of primary particles containing molybdenum trioxide ($MoO_3$) having an $\alpha$ crystal structure or a $\beta$ crystal structure, a sulfur source, and a salt of a metal in Groups 3 to 13 to obtain a mixed powder (herein also referred to as "raw material powder (1)"), and heating the mixed powder at a temperature of 200°C to 1,000°C (herein, the heating is also referred to as "calcining").

The metal-doped molybdenum sulfide powder can be produced, for example, by a production method (herein also referred to as "production method (2)") including removing, from a mixture (herein also referred to as "raw material mixture (1)") containing a molybdenum trioxide powder made of an aggregate of primary particles containing molybdenum trioxide ($MoO_3$) having an $\alpha$ crystal structure or a $\beta$ crystal structure, a salt of a metal in Groups 3 to 13, and a dispersion medium, the dispersion medium to obtain a solid (herein also referred to as "solid (1)"), and heating (calcining) the solid at a temperature of 200°C to 1,000°C in the presence of a sulfur source.

The metal-doped molybdenum sulfide powder can be produced, for example, by a production method (herein also referred to as "production method (3)") including removing, from a mixture (herein also referred to as "raw material mixture (2)") containing a molybdenum trioxide powder made of an aggregate of primary particles containing molybdenum trioxide ($MoO_3$) having an $\alpha$ crystal structure or a $\beta$ crystal structure, a salt of a metal in Groups 3 to 13, a sulfur source, and a dispersion medium, the dispersion medium with the temperature of the mixture being kept at 40°C or lower, to obtain a solid (herein also referred to as "solid (2)"), and heating (calcining) the solid at a temperature of 200°C to 1,000°C.

In the following, the methods will be sequentially described.

<Production Method (1)>

The molybdenum trioxide (MoOs) powder used in the production method (1) is made of an aggregate of primary particles containing molybdenum trioxide having an $\alpha$ crystal structure or a $\beta$ crystal structure. The molybdenum trioxide powder having the $\beta$ crystal structure has more favorable reactivity with sulfur than a molybdenum trioxide powder having only $\alpha$ crystals as a crystal structure in the related art, and the conversion rate $R_C$ to $MoS_2$ can be increased in a reaction with the sulfur source.

The $\beta$ crystal structure of molybdenum trioxide can be observed by the presence of a peak (in the vicinity of $2\theta$: 23.01°, No. 86426 (inorganic crystal structure database, ICSD)) attributed to the plane (011) of a $\beta$ crystal of $MoO_3$ in a spectrum obtained by the powder X-ray diffraction (XRD) using the Cu-K$\alpha$ rays as the X-ray source. The $\alpha$ crystal structure of molybdenum trioxide can be observed by the presence of a peak of the plane (021) (in the vicinity of $2\theta$: 27.32°, No. 166363 (inorganic crystal structure database, ICSD)) of an $\alpha$ crystal of $MoO_3$.

The $\beta$ crystal structure of molybdenum trioxide can be observed by the presence of peaks at wavenumbers of 773 cm$^{-1}$, 848 cm$^{-1}$, and 905 cm$^{-1}$ in a Raman spectrum obtained by Raman spectroscopy. The $\alpha$ crystal structure of molybdenum trioxide can be observed by the presence of peaks at wavenumbers of 663 cm$^{-1}$, 816 cm$^{-1}$, and 991 cm$^{-1}$.

The primary particles of the molybdenum trioxide powder preferably have an average particle diameter of 5 nm to 2,000 nm.

The average particle diameter of the primary particles of the molybdenum trioxide powder refers to an average value of primary particle diameters of 50 primary particles randomly selected when the molybdenum trioxide powder is photographed with a scanning electron microscope (SEM), the major axis (the Feret diameter of the longest portion observed) and the minor axis (the short Feret diameter in a direction perpendicular to the Feret diameter of the longest portion) of the minimum unit particles (that is, the primary particles) constituting aggregates on a two-dimensional image are measured, and an average value thereof is defined as the primary particle diameter.

The average particle diameter of the primary particles of the molybdenum trioxide powder is preferably 2,000 nm or less. From the viewpoint of reactivity with sulfur, it is more preferably 600 nm or less, further preferably 400 nm or less, and particularly preferably 200 nm or less. The average particle diameter of the primary particles of the molybdenum trioxide powder may be 10 nm or more, 20 nm or more, or 40 nm or more.

The molybdenum trioxide powder preferably has a $MoO_3$ content (purity) of 99.6% or more as measured with a fluorescent X-ray (XRF), whereby the conversion rate $R_C$ to $MoS_2$ can be increased, and it is possible to obtain molybdenum sulfide having high purity and favorable storage stability, which is not likely to generate sulfide derived from impurities.

The molybdenum trioxide powder preferably has a ratio ($\beta$ (011)/$\alpha$ (021)) of intensity of a peak attributed to the plane (011) of the $\beta$ crystal of $MoO_3$ to intensity of a peak attributed to the plane (021) of the $\alpha$ crystal of $MoO_3$ of 0.1 or more, more preferably 1.0 or more, and particularly preferably 2.0 or more, in the spectrum obtained by the powder X-ray diffraction (XRD) using the Cu-K$\alpha$ rays as the X-ray source.

From the peak intensity attributed to the plane (011) of the $\beta$ crystal of $MoO_3$ and the intensity of the peak attributed to the plane (021) of the $\alpha$ crystal of $MoO_3$, each maximum peak intensity is read to obtain the ratio ($\beta$ (011) /$\alpha$ (021)).

The molybdenum trioxide powder preferably has a specific surface area, which is measured by a BET method, of 10 m$^2$/g to 100 m$^2$/g.

In the molybdenum trioxide powder, the specific surface area is preferably 10 m$^2$/g or more, more preferably 20 m$^2$/g or more, and still more preferably 30 m$^2$/g or more from the viewpoint of reactivity with sulfur. In the molybdenum trioxide powder, the specific surface area is preferably 150 m$^2$/g or less, and may be 120 m$^2$/g or less or 100 m$^2$/g or less from the viewpoint of facilitation in production of the molybdenum trioxide powder.

In a radial distribution function of the molybdenum trioxide powder, which is obtained from an extended X-ray absorption fine structure (EXAFS) spectrum of a K absorption edge of molybdenum, a ratio (I/II) of peak intensity I caused by Mo-O to peak intensity II caused by Mo-Mo is preferably more than 0.1, more preferably 0.5 or more, and particularly preferably 1.0 or more.

As for the peak intensity I caused by Mo-O and the peak intensity II caused by Mo-Mo, each maximum peak intensity is read to obtain the ratio (I/II). The ratio (I/II) is considered to indicate that the $\beta$ crystal structure of $MoO_3$ is obtained in the molybdenum trioxide powder, and the greater the ratio (I/II), the better the reactivity with sulfur.

The molybdenum trioxide powder can be produced by vaporizing a molybdenum oxide precursor compound to form molybdenum trioxide vapor and cooling the molybdenum trioxide vapor.

The method for producing a molybdenum trioxide powder includes calcining a raw material mixture containing a molybdenum oxide precursor compound and a metal compound other than the molybdenum oxide precursor compound to vaporize the molybdenum oxide precursor compound so as to form molybdenum trioxide vapor. The ratio of the metal compound to 100% by mass of the raw material mixture is preferably 70% by mass or less in terms of oxide.

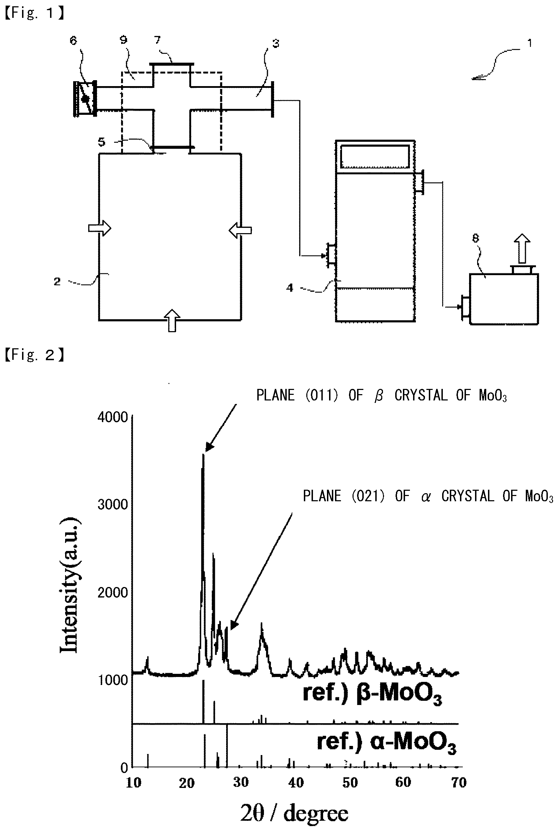

The method for producing a molybdenum trioxide powder can be suitably carried out by using a production apparatus 1 shown in FIG. 1.

FIG. 1 is a schematic view of an example of an apparatus used for producing the molybdenum trioxide powder. The production apparatus 1 includes a calcining furnace 2 for calcining a molybdenum oxide precursor compound or the raw material mixture to vaporize the molybdenum oxide precursor compound, a cross-shaped cooling pipe 3 connected to the calcining furnace 2 for powdering the molybdenum trioxide vapor vaporized by the calcining, and a collection device 4 as a collection unit for collecting the molybdenum trioxide powder powdered in the cooling pipe 3. At this time, the calcining furnace 2 and the cooling pipe 3 are connected to each other via a discharge port 5. Further, in the cooling pipe 3, an opening degree adjustment damper 6 is disposed at an outside air intake port (not shown) at a left end portion, and an observation window 7 is disposed at an upper end portion. An air exhauster 8, which is a first air blowing unit, is connected to the collection device 4. When the air exhauster 8 exhausts air, the collection device 4 and the cooling pipe 3 suction the air, and the outside air is blown into the cooling pipe 3 from the opening degree adjustment damper 6 of the cooling pipe 3. That is, the air exhauster 8 passively blows air to the cooling pipe 3 by exhibiting a suction function. In addition, the production apparatus 1 may include an external cooling device 9, which makes it possible to freely control cooling conditions for the molybdenum trioxide vapor generated from the calcining furnace 2.

The opening degree adjustment damper 6 takes in air from the outside air intake port and the molybdenum trioxide vapor vaporized in the calcining furnace 2 is cooled in an air atmosphere to obtain a molybdenum trioxide powder, whereby the ratio (I/II) can be made 0.1 or more, and the $\beta$ crystal structure of $MoO_3$ can be easily obtained in the molybdenum trioxide powder. In contrast, when the molybdenum trioxide vapor is cooled in a state where an oxygen concentration in a nitrogen atmosphere is low, for example, when the molybdenum trioxide vapor is cooled using liquid nitrogen, the oxygen defect density is likely to increase and the ratio (I/II) is likely to decrease.

The molybdenum oxide precursor compound is not particularly limited as long as it forms molybdenum trioxide vapor by being calcined, and examples thereof include metal molybdenum, molybdenum trioxide, molybdenum dioxide, molybdenum sulfide, ammonium molybdate, phosphomolybdic acid ($H_3PMo_{12}O_{40}$), silicomolybdic acid ($H_4SiMo_{12}O_{40}$), aluminum molybdate, silicon molybdate, magnesium molybdate ($MgMo_nO_{3n+1}$ (n = 1 to 3)), sodium molybdate ($Na_2Mo_nO_{3n+1}$ (n = 1 to 3)), titanium molybdate, ferric molybdate, potassium molybdate ($K_2Mo_nO_{3n+1}$ (n = 1 to 3)), zinc molybdate, boron molybdate, lithium molybdate ($Li_2Mo_nO_{3n+1}$ (n = 1 to 3)), cobalt molybdate, nickel molybdate, manganese molybdate, chromium molybdate, cesium molybdate, barium molybdate, strontium molybdate, yttrium molybdate, zirconium molybdate, and copper molybdate. These molybdenum oxide precursor compounds may be used alone or in combination of two or more thereof. The form of the molybdenum oxide precursor compound is not particularly limited, and for example, the molybdenum oxide precursor compound may be in a powder form such as molybdenum trioxide, or may be in a liquid form such as an aqueous solution of ammonium molybdate. The molybdenum oxide precursor compound is preferably in the powder form having good handling properties and good energy efficiency.

As the molybdenum oxide precursor compound, commercially available $\alpha$-crystal molybdenum trioxide is preferably used. Further, when ammonium molybdate is used as the molybdenum oxide precursor compound, the ammonium molybdate is converted by calcining into molybdenum trioxide that is thermodynamically stable, and thus the molybdenum oxide precursor compound to be vaporized becomes molybdenum trioxide.

Among these, the molybdenum oxide precursor compound preferably contains molybdenum trioxide from the viewpoint of easily controlling the purity of the obtained molybdenum trioxide powder, the average particle diameter of the primary particles, and the crystal structure.

The molybdenum trioxide vapor can also be formed by calcining a raw material mixture containing a molybdenum oxide precursor compound and a metal compound other than the molybdenum oxide precursor compound.

The metal compound other than the molybdenum oxide precursor compound is not particularly limited, and examples thereof include an aluminum compound, a silicon compound, a titanium compound, a magnesium compound, a sodium compound, a potassium compound, a zirconium compound, an yttrium compound, a zinc compound, a copper compound, and an iron compound. Among these, it is preferable to use the aluminum compound, the silicon compound, the titanium compound, or the magnesium compound as the metal compound.

The molybdenum oxide precursor compound and the metal compound other than the molybdenum oxide precursor compound may form an intermediate, but even in this case, the intermediate is decomposed by calcining, and molybdenum trioxide can be vaporized in a thermodynamically stable form.

As the metal compound other than the molybdenum oxide precursor compound, an aluminum compound is preferably used to prevent damage to a calcining furnace. In the production method, the metal compound other than the molybdenum oxide precursor compound may not be used to improve the purity of the molybdenum trioxide powder.

Examples of the aluminum compound include aluminum chloride, aluminum sulfate, basic aluminum acetate, aluminum hydroxide, boehmite, pseudo-boehmite, aluminum oxides ($\alpha$-aluminum oxide, $\gamma$-aluminum oxide, $\delta$-aluminum

oxide, θ-aluminum oxide, etc.), and a mixed aluminum oxide having two or more crystal phases.

When a raw material mixture containing a molybdenum oxide precursor compound and a metal compound other than the molybdenum oxide precursor compound is calcined, the content of the molybdenum oxide precursor compound is preferably 40% by mass to 100% by mass, and may be 45% by mass to 100% by mass or 50% by mass to 100% by mass with respect to 100% by mass of the raw material mixture.

The calcining temperature varies depending on the molybdenum oxide precursor compound, the metal compound to be used, the desired molybdenum trioxide powder, and the like, and is usually preferably a temperature at which the intermediate can be decomposed. For example, since aluminum molybdate can be formed as an intermediate when a molybdenum compound is used as the molybdenum oxide precursor compound and an aluminum compound is used as the metal compound, the calcining temperature is preferably 500°C to 1,500°C, more preferably 600°C to 1,550°C, and still more preferably 700°C to 1,600°C.

The calcining time is not particularly limited, and may be, for example, 1 minute to 30 hours, 10 minutes to 25 hours, or 100 minutes to 20 hours.

The temperature rising rate varies depending on the molybdenum oxide precursor compound and the metal compound to be used, and the properties of the desired molybdenum trioxide powder, and is preferably 0.1°C/min to 100°C/min, more preferably 1°C/min to 50°C/min, and still more preferably 2°C/min to 10°C/min from the viewpoint of production efficiency.

The internal pressure in the calcining furnace is not particularly limited, and may be a positive pressure or a reduced pressure, but from the viewpoint of suitably discharging the molybdenum oxide precursor compound from the calcining furnace to the cooling pipe, the calcining is preferably performed under a reduced pressure. Specifically, the degree of pressure reduction is preferably -5,000 Pa to -10 Pa, more preferably -2,000 Pa to -20 Pa, and still more preferably -1,000 Pa to -50 Pa. When the degree of pressure reduction is -5,000 Pa or more, high airtightness and mechanical strength of the calcining furnace are not excessively required, and production costs can be reduced, which is preferable. When the degree of pressure reduction is -10 Pa or less, clogging of the molybdenum oxide precursor compound at a discharge port of the calcining furnace can be prevented, which is preferable.

When a gas is blown into the calcining furnace during calcining, the temperature of the blown gas is preferably 5°C to 500°C, and more preferably 10°C to 100°C.

Further, the blowing speed of the gas is preferably 1 L/min to 500 L/min, and more preferably 10 L/min to 200 L/min with respect to 100 L of an effective volume of the calcining furnace.

The temperature of the vaporized molybdenum trioxide vapor varies depending on the type of the molybdenum oxide precursor compound to be used, and is preferably 200°C to 2,000°C, and more preferably 400°C to 1,500°C. When the temperature of the vaporized molybdenum trioxide vapor is 2,000°C or lower, usually, the vapor tends to be easily powdered by blowing outside air (0°C to 100°C) to the cooling pipe.

The discharge rate of the molybdenum trioxide vapor discharged from the calcining furnace can be controlled based on the amount of the molybdenum oxide precursor compound to be used, the amount of the metal compound to be used, the temperature of the calcining furnace, blowing of the gas into the calcining furnace, and the diameter of the discharge port of the calcining furnace. The discharge rate of the molybdenum trioxide vapor discharged from the calcining furnace to the cooling pipe varies depending on the cooling capacity of the cooling pipe, and is preferably 0.001 g/min to 100 g/min, and more preferably 0.1 g/min to 50 g/min.

Further, the content of the molybdenum trioxide vapor contained in the gas discharged from the calcining furnace is preferably 0.01 mg/L to 1,000 mg/L, and more preferably 1 mg/L to 500 mg/L.

Next, the molybdenum trioxide vapor is cooled to be powdered.

The molybdenum trioxide vapor is cooled by lowering the temperature of the cooling pipe. In this case, examples of cooling include cooling by blowing a gas into the cooling pipe as described above, cooling by a cooling mechanism included in the cooling pipe, and cooling by an external cooling device.

The molybdenum trioxide vapor is preferably cooled in an air atmosphere. When the molybdenum trioxide vapor is cooled in an air atmosphere to form a molybdenum trioxide powder, the ratio (I/II) can be 0.1 or more, and the β crystal structure of $MoO_3$ can be easily obtained in the molybdenum trioxide powder.

The cooling temperature (temperature of the cooling pipe) is not particularly limited, and is preferably -100°C to 600°C, and more preferably -50°C to 400°C.

The cooling rate of the molybdenum trioxide vapor is not particularly limited, and is preferably 100°C/s to 100,000°C/s, and more preferably 1,000°C/s to 50,000°C/s. As the cooling rate of the molybdenum trioxide vapor increases, a molybdenum trioxide powder having a small particle diameter and a large specific surface area tends to be obtained. The content of the β crystal structure of molybdenum trioxide is high.

When the cooling is performed by blowing a gas into the cooling pipe, the temperature of the blown gas is preferably -100°C to 300°C, and more preferably -50°C to 100°C.

Further, the blowing speed of the gas is preferably 0.1 m³/min to 20 m³/min, and more preferably 1 m³/min to 10 m³/min. When the blowing speed of the gas is 0.1 m³/min or more, a high cooling rate can be achieved, and clogging in the cooling pipe can be prevented, which is preferable. In contrast, when the blowing speed of the gas is 20 m$^3$/min or less, the first air blowing unit (such as an air exhauster) which is expensive is no longer needed, and production costs can be reduced, which is preferable.

The powder obtained by cooling the molybdenum trioxide vapor is transported to the collection device for collection.

In the method for producing a molybdenum trioxide powder, the powder obtained by cooling the molybdenum trioxide vapor may be calcined again at a temperature of 100°C to 320°C.

That is, the molybdenum trioxide powder obtained by the method for producing a molybdenum trioxide powder may be calcined again at a temperature of 100°C to 320°C. The calcining temperature in the re-calcining may be 120°C to 280°C or 140°C to 240°C. A calcining time in the re-calcining may be, for example, 1 minute to 4 hours, 10 minutes to 5 hours, or 100 minutes to 6 hours. However, the crystal size of molybdenum trioxide is increased due to re-calcining at a temperature of 350°C or higher, the $\beta$ crystal structure of the molybdenum trioxide powder disappears, the ratio ($\beta$ (011)/$\alpha$ (021)) is 0, and the reactivity with sulfur is impaired.

The sulfur source is a component having a sulfur atom, and examples thereof include sulfur and hydrogen sulfide.

The raw material powder (1) may contain only one type of the sulfur source or two or more types thereof.

In the raw material powder (1), the amount of the sulfur source blended is preferably 3 to 20 times by mole, more preferably 4 to 15 times by mole, and further preferably 5 to 10 times by mole the amount of the molybdenum trioxide powder blended. When the amount of the sulfur source blended is equal to or more than the lower limit value, the yield of the metal-doped molybdenum sulfide powder is higher. When the amount of the sulfur source blended is equal to or less than the upper limit value, the amount of the sulfur source mixed or impurity derived from the sulfur source in the metal-doped molybdenum sulfide powder is lower.

The salt of the metal in Groups 3 to 13 is not particularly limited as long as it is a salt considered to be made of a cation of the metal in Groups 3 to 13 and an anion.

The raw material powder (1) may contain only one type of the salt of the metal in Groups 3 to 13 or two or more types thereof.

The anion may be any of an inorganic anion (an inorganic component is anionized) or an organic anion (an organic component is anionized).

Examples of the inorganic anion include halide ions such as a chloride ion (Cl-), a bromide ion (Br-), and an iodide ion (I$^-$); and oxyanions such as a nitrate ion (NO$_3^-$), a sulfate ion (SO$_4^{2-}$), a carbonate ion (CO$_3^{2-}$), a bicarbonate ion (HCO$_3^-$), a phosphate ion (PO$_4^{3-}$), a hydrogenphosphate ion (HPO$_4^{2-}$), and a dihydrogenphosphate ion (H$_2$PO$_4^-$).

Examples of the organic anion include organic acid ions such as an acetate ion (CH$_3$COO$^-$), a bisacetate ion, a lactate ion, a bis(L-lactate) ion, a gluconate ion, a citrate ion, a propionate ion, a 2-ethylhexanate ion, a tartrate ion, a dibenzyl dithiocarbamate ion, a succinate ion, and an isethionate ion.

The salt of the metal in Groups 3 to 13 is preferably a salt considered to be made of the cation of the metal in Groups 3 to 13 and the inorganic anion, more preferably a salt considered to be made of the cation of the metal in Groups 3 to 13 and a halide ion or an oxyanion, and further preferably a chloride or a nitrate.

Examples of the chloride include cobalt chloride (CoCl$_2$), palladium chloride (PdCl$_2$), iridium chloride (IrCl$_3$), manganese chloride (MnCl$_2$), iron (III) chloride (FeCl$_3$), nickel chloride (NiCl$_2$), ruthenium chloride (RuCl$_3$), and zinc chloride (ZnCl$_2$).

Examples of the nitrate include cobalt nitrate (Co(NO$_3$)$_2$), zirconium oxynitrate (ZrO(NO$_3$)$_2$), and indium nitrate (In(NO$_3$)$_3$).

A hydrate of the salt of the metal in Groups 3 to 13 may be used.

Examples of the hydrate of the salt of the metal in Groups 3 to 13 include cobalt nitrate hexahydrate (Co(NO$_3$)$_2$·6H$_2$O), cobalt chloride hexahydrate (CoCl$_2$·6H$_2$O), manganese chloride tetrahydrate (MnCl$_2$·4H$_2$O), iron (III) chloride hexahydrate (FeCl$_3$·6H$_2$O), nickel chloride hexahydrate (NiCl$_2$·6H$_2$O), zirconium oxynitrate dihydrate (ZrO(NO$_3$)$_2$·2H$_2$O), and indium nitrate trihydrate (In(NO$_3$)$_3$·3H$_2$O).

The salt of the metal in Groups 3 to 13 blended in the production method (1) is preferably one or two or more selected from the group consisting of cobalt nitrate hexahydrate, cobalt chloride hexahydrate, palladium chloride, iridium chloride, manganese chloride tetrahydrate, iron (III) chloride hexahydrate, nickel chloride hexahydrate, zirconium oxynitrate dihydrate, ruthenium chloride, indium nitrate trihydrate, and zinc chloride.

The amount of the salt of the metal in Groups 3 to 13 blended in the raw material powder (1) is preferably 0.2 mol% to 10 mol%, more preferably 0.4 mol% to 7 mol%, and further preferably 0.6 mol% to 4 mol%, with respect to the amount of the molybdenum trioxide powder blended. When the blending amount of the salt of the metal in Groups 3 to 13 falls within such a range, various activities of the metal-doped molybdenum sulfide powder are higher.

A ratio of the total amount of the molybdenum trioxide powder, the sulfur source, and the salt of the metal in Groups 3 to 13 blended to the total blending amount of all the blending components in the raw material powder (1) is preferably 90 mass% or more, more preferably 95 mass% or more, further preferably 97 mass% or more, and particularly preferably 99 mass% or more. When the ratio is equal to or more than the lower limit value, various activities of the metal-doped molybdenum sulfide powder are higher. The ratio is 100 mass% or less.

The raw material powder (1) in the production method (1) is not limited as long as all the blending components are dry-mixed, and preferably uniformly mixed. For example, all the blending components may be ground until a particulate material is not visually recognized in the raw material powder.

Herein, "dry-mixing" means mixing a target component without intentionally using a liquid component at normal temperature.

Dry-mixing for obtaining the raw material powder (1) can be carried out, for example, under a temperature condition of 5°C to 40°C.

A time of dry-mixing for obtaining the raw material powder (1) may be, for example, 5 minutes to 120 minutes.

A method for dry-mixing the blending components is not particularly limited. For example, the blending components may be mixed with an automatic mixer such as a magnet mortar or a dancing mill, or relatively small amounts of blending components may be mixed by grinding with a mortar and a pestle.

A condition of calcining the raw material powder (1) in the production method (1) can be appropriately controlled.

The calcining temperature is not limited as long as it is a temperature at which sulfurization of molybdenum trioxide sufficiently proceeds, and is preferably 320°C or higher, more preferably 340°C or higher, and particularly preferably 360°C or higher. The calcining temperature may be, for example, 320°C to 1,000°C, 340°C to 800°C, or 360°C to 600°C.

The calcining time is not limited as long as it is a temperature at which sulfurization of molybdenum trioxide sufficiently proceeds, and is preferably 2 hours to 8 hours, more preferably 2.5 hours to 6.5 hours, and particularly preferably 3 hours to 5 hours.

It is preferable that calcining be carried out in the presence of an inert gas, such as a nitrogen atmosphere.

For example, in the case of calcining under a flow of an inert gas, the flow rate of the inert gas is preferably a flow rate at which the whole amount of gas in a calcining chamber can be replaced once in 1 minute to 5 minutes. For example, when the volume of the calcining chamber is 1 L, the flow rate of the inert gas is preferably 200 mL/min to 1,000 mL/min.

In the production method (1), a ratio of the amount of the raw material powder (1) used to the total amount of all the components used in heating (calcining) at a temperature of 200°C to 1,000°C is preferably 90 mass% or more, more preferably 95 mass% or more, further preferably 97 mass% or more, and particularly preferably 99 mass% or more. When the ratio is equal to or more than the lower limit value, various activities of the metal-doped molybdenum sulfide powder are higher.

The ratio is 100 mass% or less.

In the production method (1), the metal-doped molybdenum sulfide powder can be produced by at least preparing the raw material powder (1), and heating (calcining) the raw material powder (1) at a temperature of 200°C to 1,000°C.

In the production method (1), any one or two or more operations except for preparing the raw material powder (1) and calcining the raw material powder (1) may be carried out once or twice or more times at an appropriate timing as long as the metal-doped molybdenum sulfide powder is obtained.

The production method (1) is excellent in producing the metal-doped molybdenum sulfide powder at low cost by a simple operation.

<Production Method (2)>

The molybdenum trioxide (MoOs) powder, the salt of the metal in Groups 3 to 13, and the sulfur source used in the production method (2) are the same as the molybdenum trioxide powder, the salt of the metal in Groups 3 to 13, and the sulfur source, used in the production method (1), respectively.

The dispersion medium used in the production method (2) is not particularly limited, and can be appropriately selected form substances usually usable as a solvent.

In consideration of removing the dispersion medium from the raw material mixture (1), the dispersion medium is preferably a dispersion medium having a low boiling point.

Examples of the dispersion medium include water, acetone, acetonitrile, tetrahydrofuran (THF), hexane, heptane, toluene, methanol, ethanol, propanol (1-propanol, 2-propanol), butanol (1-butanol, 2-butanol), and hexanol (1-hexanol, 2-hexanol). In terms of dissolving the salt of the metal in Groups 3 to 13, preferred examples of the dispersion medium include water, acetone, acetonitrile, and methanol.

The raw material mixture (1) may contain only one type of the dispersion medium or two or more types thereof.

In the raw material mixture (1), the molybdenum trioxide powder is dispersed, and the salt of the metal in Groups 3 to 13 is dissolved or dispersed. That is, the dispersion medium can function as a solvent for some of the blending components.

The amount of the salt of the metal in Groups 3 to 13 blended in the raw material mixture (1) is preferably 0.2 mol% to 10 mol%, more preferably 0.4 mol% to 7 mol%, and further preferably 0.6 mol% to 4 mol%, with respect to the amount of the molybdenum trioxide powder blended. When the blending amount of the salt of the metal in Groups 3 to 13 falls within such a range, various activities of the metal-doped molybdenum sulfide powder are higher.

The amount of the dispersion medium blended in the raw material mixture (1) is preferably 1 to 300 times by mass, more preferably 25 to 200 times by mass, and further preferably 50 to 100 times by mass the amount of the molybdenum trioxide powder blended. When the amount of the dispersion medium blended falls within such a range, the handleability of the raw material mixture (1) is higher.

A ratio of the total amount of the molybdenum trioxide powder, the salt of the metal in Groups 3 to 13, and the dispersion medium blended to the total amount of all the blending components in the raw material mixture (1) is preferably 90 mass% or more, more preferably 95 mass% or more, further preferably 97 mass% or more, and particularly preferably 99 mass% or more. When the ratio is equal to or more than the lower limit value, various activities of the metal-doped molybdenum sulfide powder are higher, and the handleability of the raw material mixture (1) is higher.

The ratio is 100 mass% or less.

The raw material mixture (1) can be prepared by blending the molybdenum trioxide powder, the salt of the metal in Groups 3 to 13, and the dispersion medium. The order of blending the components is not particularly limited. The components may be independently and successively blended, or the components may be partially mixed in advance and the obtained mixture may be blended.

For example, the raw material mixture (1) may be prepared by mixing a dispersion liquid of the molybdenum trioxide powder that is a blend of the molybdenum trioxide powder and the dispersion medium, and a dispersion liquid or solution of the salt of the metal in Groups 3 to 13 that is a blend of the salt of the metal in Groups 3 to 13 and the dispersion medium (solvent).

In preparation of the raw material mixture (1) in the production method (2), the raw material mixture (1) may be prepared by blending all the components and stirring the obtained blend, for example, at 10°C to 35°C for 0.5 hours to 12 hours.

In the production method (2), a method for removing the dispersion medium from the raw material mixture (1) is not particularly limited as long as the dispersion medium (solvent) can be removed (that is, dried). Examples of the method for removing the dispersion medium (drying method) include a drying method using a blow dryer or a rotary evaporator, and a drying method by freeze drying. Examples of a method suitable for a large scale production include a method for removing the dispersion medium from the raw material mixture (1) by freeze-drying the raw material mixture (1) (herein also referred to as "drying method (1)") and a method for removing the dispersion medium from the raw material mixture (1) by heating the raw material mixture (1) (herein also referred to as "drying method (2)").

A condition of freeze drying in the drying method (1) is not particularly limited. For example, the dispersion medium can be removed from the raw material mixture (1) by freezing the raw material mixture (1) using a mixture of dry ice and methanol as a refrigerant, and then maintaining an atmosphere where the raw material mixture (1) exists in a vacuum state using a rotary pump or the like.

In the drying method (2), the raw material mixture (1) may be heated, for example, at 50°C to 200°C for 0.5 hours to 6 hours. At that time, it is preferable that the raw material mixture (1) be heated while air is blown.

The method for removing the water from the raw material mixture (1) is preferably the drying method (1) from the viewpoint of obtaining the solid (1) with more uniform quality by a simpler method.

In the production method (2), the amount (blending amount) of the sulfur source that coexists with the solid (1) is preferably 3 to 20 times by mole, more preferably 4 to 15 times by mole, and further preferably 5 to 10 times by mole the amount of the molybdenum trioxide powder blended. When the amount of the sulfur source blended is equal to or more than the lower limit value, the yield of the metal-doped molybdenum sulfide powder is higher. When the amount of the sulfur source blended is equal to or less than the upper limit value, the amount of the sulfur source mixed or impurity derived from the sulfur source in the metal-doped molybdenum sulfide powder is lower.

Herein, the amount (mol) of the molybdenum trioxide powder blended means an amount obtained by multiplying the amount (mol) of the molybdenum trioxide powder blended during preparation of the raw material mixture (1) by the amount (part by mass) of the solid (1) used, and dividing the result by the whole amount (part by mass) of the solid (1) ([amount (mol) of molybdenum trioxide powder blended during preparation of raw material mixture (1)] $\times$ [amount (part by mass) of solid (1) used]/[whole amount (part by mass) of solid (1) . When the whole amount of the obtained solid (1) is used, the amount (mol) of the molybdenum trioxide powder blended means the amount (mol) of the molybdenum trioxide powder blended during preparation of the raw material mixture (1).

A condition of calcining the solid (1) in the production method (2) can be appropriately controlled.

For example, the condition of calcining the solid (1) in the presence of the sulfur source in the production method (2) may be the same as the condition of calcining the raw material powder (1) in the production method (1).

In the production method (2), a ratio of the total amount of the solid (1) and the sulfur source used to the total amount of all the blending components used in heating (calcining) at a temperature of 200°C to 1,000°C is preferably 90 mass% or more, more preferably 95 mass% or more, further preferably 97 mass% or more, and particularly preferably 99 mass% or more. When the ratio is equal to or more than the lower limit value, various activities of the metal-doped molybdenum sulfide powder are higher.

The ratio is 100 mass% or less.

In the production method (2), the metal-doped molybdenum sulfide powder can be produced by at least producing the solid (1) from the raw material mixture (1), and then calcining the solid (1) in the presence of the sulfur source.

In the production method (2), any one or two or more operations except for producing the solid (1) from the raw material mixture (1) and then calcining the solid (1) in the presence of the sulfur source may be carried out once or twice or more times at an appropriate timing as long as the metal-doped molybdenum sulfide powder is obtained.

The production method (2) is excellent from the viewpoint of producing the metal-doped molybdenum sulfide powder with more uniform quality. The production method (2) using the drying method (1) is especially excellent from the viewpoint of producing the metal-doped molybdenum sulfide powder with still more uniform quality.

<Production Method (3)>

The molybdenum trioxide (MoOs) powder, the salt of the metal in Groups 3 to 13, and the sulfur source used in the production method (3) are the same as the molybdenum trioxide powder, the salt of the metal in Groups 3 to 13, and the sulfur source, used in the production method (1), respectively.

The dispersion medium used in the production method (3) is the same as the dispersion medium used in the production method (2).

The raw material mixture (2) may contain only one type of the dispersion medium or two or more types thereof.

In the raw material mixture (2), the molybdenum trioxide powder is dispersed, the sulfur source is dissolved or dispersed, and the salt of the metal in Groups 3 to 13 is dissolved or dispersed. That is, the dispersion medium can function as a solvent for some of the blending components.

The amount of the salt of the metal in Groups 3 to 13 blended in the raw material mixture (2) is preferably 0.2 mol% to 10 mol%, more preferably 0.4 mol% to 7 mol%, and further preferably 0.6 mol% to 4 mol%, with respect to the amount of the molybdenum trioxide powder blended. When the blending amount of the salt of the metal in Groups 3 to 13 falls within such a range, various activities of the metal-doped molybdenum sulfide powder are higher.

In the raw material mixture (2), the amount of the sulfur source blended is preferably 3 to 20 times by mole, more preferably 4 to 15 times by mole, and further preferably 5 to 10 times by mole the amount of the molybdenum trioxide powder blended. When the amount of the sulfur source blended is equal to or more than the lower limit value, the yield of the metal-doped molybdenum sulfide powder is higher. When the amount of the sulfur source blended is equal to or less than the upper limit value, the amount of the sulfur source mixed or impurity derived from the sulfur source in the metal-doped molybdenum sulfide powder is lower.

The amount of the dispersion medium blended in the raw material mixture (2) is preferably 1 to 300 times by mass, more preferably 5 to 150 times by mass, and further preferably 10 to 90 times by mass the amount of the molybdenum trioxide powder blended. When the amount of the dispersion medium blended falls within such a range, the handleability of the raw material mixture (2) is higher.

A ratio of the total amount of the molybdenum trioxide powder, the salt of the metal in Groups 3 to 13, the sulfur source, and the dispersion medium blended to the total amount of all the blending components in the raw material mixture (2) is preferably 90 mass% or more, more preferably 95 mass% or more, further preferably 97 mass% or more, and particularly preferably 99 mass% or more. When the ratio is equal to or more than the lower limit value, various activities of the metal-doped molybdenum sulfide powder are higher, and the handleability of the raw material mixture (2) is higher.

The ratio is 100 mass% or less.

The raw material mixture (2) can be prepared by blending the molybdenum trioxide powder, the salt of the metal in Groups 3 to 13, the sulfur source, and the dispersion medium. The order of blending the components is not particularly limited. The components may be independently and successively blended, or the components may be partially mixed in advance and the obtained mixture may be blended.

For example, the raw material mixture (2) may be prepared by mixing a dispersion liquid of the molybdenum trioxide powder that is a blend of the molybdenum trioxide powder and the dispersion medium, a dispersion liquid or solution of the salt of the metal in Groups 3 to 13 that is a blend of the salt of the metal in Groups 3 to 13 and the dispersion medium (solvent), and the sulfur source.

In preparation of the raw material mixture (2) in the production method (3), the raw material mixture (2) may be prepared by blending all the components and stirring the obtained blend, for example, at 10°C to 35°C for 0.5 hours to 12 hours.

In the production method (3), a method for removing the dispersion medium from the raw material mixture (2) is not particularly limited as long as the dispersion medium (solvent) can be removed (that is, dried) while the temperature of the raw material mixture (2) is kept to 100°C or lower. Examples of the method for removing the dispersion medium include a method for removing the dispersion medium using a rotary evaporator, and a method for removing the dispersion medium by freeze drying. Preferred examples thereof include a method for removing the dispersion medium from the raw material mixture (2) at a temperature near room temperature by freeze-drying the raw material mixture (2) (herein also referred to as "drying method (3)").

The drying method (3) is preferred from the viewpoint of obtaining the solid (2) with more uniform quality by a simpler method.

A condition of freeze drying in the drying method (3) is not particularly limited.

For example, the condition of freeze drying in the drying method (3) may be the same as the condition of freeze drying in the drying method (1).

A condition of calcining the solid (2) in the production method (3) can be appropriately controlled.

For example, the condition of calcining the solid (2) in the production method (3) may be the same as the condition of calcining the raw material powder (1) in the production method (1).

In the production method (3), a ratio of the amount of the solid (2) used to the total amount of all the components used in heating (calcining) at a temperature of 200°C to 1,000°C is preferably 90 mass% or more, more preferably 95 mass% or more, further preferably 97 mass% or more, and particularly preferably 99 mass% or more. When the ratio is equal to or more than the lower limit value, various activities of the metal-doped molybdenum sulfide powder are higher.

The ratio is 100 mass% or less.

In the production method (3), the metal-doped molybdenum sulfide powder can be produced by at least producing the solid (2) from the raw material mixture (2), and then calcining the solid (2). In the production method (3), any one or two or more operations except for producing the solid (2) from the raw material mixture (2) and then calcining the solid (2) may be carried out once or twice or more times at an appropriate timing as long as the metal-doped molybdenum sulfide powder is obtained.

The production method (3) is especially excellent from the viewpoint of producing the metal-doped molybdenum sulfide powder with still more uniform quality.

<<Catalyst Ink>>

A catalyst ink according to a third embodiment of the present invention contains one or two or more hydrogen generation catalysts selected from the group consisting of the hydrogen generation catalyst according to the first embodiment and the hydrogen generation catalyst according to the second embodiment, and a solvent. In addition, the catalyst ink may contain a polyelectrolyte.

Examples of the solvent include a solvent that is capable of dispersing the hydrogen generation catalyst and can be applied to a base material for a working electrode to form a catalyst layer. The solvent is preferably a solvent capable of dispersing a polyelectrolyte, or a solvent that can be removed at normal temperature or 100°C or lower during formation of the catalyst layer.

Specific examples of the solvent include water, acetone, acetonitrile, tetrahydrofuran (THF), hexane, heptane, toluene, methanol, ethanol, propanol (1-propanol, 2-propanol), butanol (1-butanol, 2-butanol), pentanol (1-pentanol, 2-pentanol), hexanol (1-hexanol, 2-hexanol), and heptanol (1-heptanol, and 2-heptanol).

The catalyst ink may contain only one type of the solvent or two or more types thereof.

The content of the solvent in the catalyst ink is preferably 1 to 300 times by mass, more preferably 10 to 150 times by mass, and further preferably 30 to 75 times by mass the content of the hydrogen generation catalyst. When the content of the solvent falls within such a range, the handleability of the catalyst ink is higher, and the generation of aggregate in the catalyst ink can also be suppressed.

When the catalyst ink contains the polyelectrolyte, the conductivity of the catalyst ink is increased, and the aggregation of molybdenum sulfide in the catalyst ink can be further suppressed.

The polyelectrolyte may be a polyelectrolyte generally used in a catalyst layer for a fuel cell.

Examples of the polyelectrolyte include a perfluorocarbon polymer having a sulfo group (for example, Nafion (registered trademark)), a hydrocarbon-based polymer compound having a sulfo group, a polymer compound doped with an inorganic acid such as phosphoric acid, organic/inorganic hybrid polymers partially substituted with proton-conducting functional groups, and a proton conductor in which a polymer matrix is impregnated with a phosphoric acid solution or a sulfuric acid solution.

The catalyst ink may contain only one type of the polyelectrolyte or two or more types thereof.

When the catalyst ink contains the polyelectrolyte, the content of the polyelectrolyte in the catalyst ink is preferably 0.1 mass% to 20 mass%, more preferably 0.5 mass% to 10 mass%, and further preferably 1 mass% to 5 mass%, with respect to the content of the hydrogen generation catalyst. When the content of the polyelectrolyte falls within such a range, a catalyst effect in the hydrogen evolution reaction (HER) is higher.

A ratio of the total content (part by mass) of the hydrogen generation catalyst, the polyelectrolyte, and the solvent in the catalyst ink to the whole mass of the catalyst ink is preferably 80 mass% or more, more preferably 90 mass% or more, and further preferably 95 mass% or more, and may be, for example, any of 97 mass% or more and 99 mass% or more, or 100 mass%. When the ratio is equal to or more than the lower limit value, the catalytic activities of the catalyst ink and the catalyst layer formed from the catalyst ink in the hydrogen evolution reaction (HER) are higher. The ratio is 100 mass% or less.

[Examples]

Hereinafter, the present invention will be described in more detail by specific examples. However, the present invention is not limited to the following examples.

Physical properties of each item were evaluated by the following methods.

<Method for Measuring Average Particle Diameter of Primary Particles of Molybdenum Trioxide Powder>

Molybdenum trioxide particles constituting a molybdenum trioxide powder were photographed with a scanning electron microscope (SEM). The major axis (the Feret diameter of the longest portion observed) and the minor axis (the short Feret diameter in a direction perpendicular to the Feret diameter of the longest portion) of the minimum unit particles (that is, primary particles) constituting aggregates on a two-dimensional image were measured, and an average value thereof was defined as the primary particle diameter. The same operation was performed on 50 primary particles randomly selected, and the average particle diameter of the primary particles was calculated based on the average value of the primary particle diameters of these primary particles.

<Purity Measurement of Molybdenum Trioxide: XRF Analysis>

About 70 mg of a sample of a molybdenum trioxide powder collected was taken on a filter paper and covered with a PP film, and the composition of the molybdenum trioxide powder was analyzed using an X-ray fluorescence analyzer Primus IV (manufactured by Rigaku Corporation). The amount of molybdenum determined based on an XRF (X-ray fluorescence) analysis result was determined in terms of molybdenum trioxide (% by mass) with respect to 100% by mass of the molybdenum trioxide powder.

<Measurement of Metal Doping Amount of Metal-Doped Molybdenum Sulfide Powder: XRF Analysis>

About 70 mg of a sample of a metal-doped molybdenum sulfide powder was taken on a filter paper and covered with a PP film, and the composition of the sample was analyzed using an X-ray fluorescence analyzer Primus IV (manufactured by Rigaku Corporation). A ratio of the amount (molar amount) of metal determined from an XRF (X-ray fluorescence) analysis result to the amount (molar amount) of molybdenum in the metal-doped molybdenum sulfide powder was calculated, which was a metal doping amount.

<Crystal Structure Analysis: XRD Method>

A sample of a molybdenum trioxide powder, a molybdenum sulfide powder, or a metal-doped molybdenum sulfide powder was placed in a holder for a measurement sample having a depth of 0.5 mm, set in a wide-angle X-ray diffraction (XRD) apparatus (Ultima IV manufactured by Rigaku Corporation), and was subjected to measurement under conditions of Cu/K$\alpha$ rays, 40 kV/40 mA, a scanning speed of 2°/min, and a scanning range of 10° or more and 70° or less.

<Measurement of Specific Surface Area: BET Method>

A sample of a molybdenum trioxide powder, a molybdenum sulfide powder, or a metal-doped molybdenum sulfide powder was subjected to measurement with a specific surface area meter (BELSORP-mini manufactured by MicrotracBEL), and the surface area per gram of the sample measured based on the amount of the adsorbed nitrogen gas by the BET method was calculated as the specific surface area ($m^2/g$).

<Calculation of Conversion Rate $R_C$ to $MoS_2$>

A black molybdenum sulfide powder was subjected to X-ray diffraction (XRD) measurement. Next, by the reference intensity ratio (RIR) method, the conversion rate $R_C$ to $MoS_2$ was obtained according to the following equation (1) using the RIR value $K_A$ of molybdenum sulfide ($MoS_2$), the integrated intensity $I_A$ of the peak in the vicinity of 20 = 14.4° $\pm$ 0.5° attributed to the plane (002) or the plane (003) of molybdenum sulfide ($MoS_2$), the RIR value $K_B$ of each molybdenum oxide ($MoO_3$ as a raw material, and $Mo_9O_{25}$, $Mo_4O_{11}$, $MoO_2$, etc. as reaction intermediates), and the integrated intensity $I_B$ of the strongest line peak of each molybdenum oxide ($MoO_3$ as a raw material, and $Mo_9O_{25}$, $Mo_4O_{11}$, $MoO_2$, etc. as reaction intermediates).

$$R_C \ (\%) \ = \ (I_A/K_A)/(\Sigma(I_B/K_B)) \ \times \ 100 \qquad (1)$$

Here, values described in the inorganic crystal structure database (ICSD) were used as the RIR values, and integrated X-ray powder diffraction software (PDXL) (Rigaku Corporation) was used for analysis.

<Measurement of Extended X-ray Absorption Fine Structure (EXAFS)>

In a mortar, 36.45 mg of a molybdenum sulfide powder and 333.0 mg of boron nitride were mixed. 123.15 mg of the mixture was weighed and compression molded into a tablet having a diameter of 8 mm to obtain a measurement sample. Using the measurement sample, the extended X-ray absorption fine structure (EXAFS) was measured by a transmission method with BL5S1 of Aichi Synchrotron Radiation Center. Athena (Internet <URL: https://bruceravel.github.io/demeter/>) was used for analysis.

<Measurement of Median Diameter $D_{50}$ of Metal-Doped Molybdenum Sulfide Powder or Molybdenum Sulfide Powder>

To 20 mL of acetone, 0.1 g of a metal-doped molybdenum sulfide powder or a molybdenum sulfide powder was added and subjected to an ultrasonic treatment in an ice bath for 4 hours, and then the concentration thereof was appropriately adjusted with acetone to a concentration within a measurable range of a dynamic light scattering type particle diameter distribution measuring device (Nanotrac Wave II manufactured by MicrotracBEL) to obtain a measurement sample. Using the measurement sample, the particle diameter distribution in the range of particle diameters of 0.0001 um to 10 um was measured by a dynamic light scattering type particle diameter distribution measuring device (Nanotrac Wave II manufactured by MicrotracBEL) to calculate the median diameter $D_{50}$.
However, for those having a median diameter $D_{50}$ more than 10 um, a solution was similarly prepared, and the particle diameter distribution in the range of particle diameters of 0.015 um to 500 um was measured with a laser diffraction particle size distribution analyzer (SALD-7000 manufactured by Shimadzu Corporation) to calculate the median diameter $D_{50}$.

<Method (1) for Observing Particle Shape of Metal-Doped Molybdenum Sulfide Powder or Molybdenum Sulfide Powder>

A metal-doped molybdenum sulfide powder or a molybdenum sulfide powder was photographed with a transmission electron microscope (TEM) (JEOL JEM1400), and 50 primary particles in the field of view of a two-dimensional image were observed.

<Method (2) for Observing Particle Shape of Metal-Doped Molybdenum Sulfide Powder or Molybdenum Sulfide Powder>

A metal-doped molybdenum sulfide powder or a molybdenum sulfide powder was photographed with a scanning electron microscope (SEM) (JEOL JCM7000), and the shapes of particles were observed.

<Method (3) for Observing Particle Shape of Metal-Doped Molybdenum Sulfide Powder or Molybdenum Sulfide Powder>

A metal-doped molybdenum sulfide powder was subjected to measurement with an atomic force microscope (AFM) (Oxford Cypher-ES), and the shapes of particles were observed.

<Analysis of Element Distribution of Metal-Doped Molybdenum Sulfide Powder>

A metal-doped molybdenum sulfide powder was observed by an energy-dispersive X-ray spectroscopy (EDS) with a scanning electron microscope (SEM) (JEOL JCM7000), and a distribution state of elements in the powder was analyzed.

[Example 1]

<<Production of Hydrogen Generation Catalyst (Molybdenum Sulfide Powder)>>

<Production of Molybdenum Trioxide Powder Having β Crystal Structure>

1 kg of a transition aluminum oxide (activated alumina manufactured by Wako Pure Chemical Industries, Ltd., average particle diameter: 45 um) and 1 kg of molybdenum trioxide (manufactured by TAIYO KOKO Co., Ltd.) were mixed with each other, and the mixture was then placed in a sagger and calcined at a temperature of 1,100°C for 10 hours in the calcining furnace 2 of the production apparatus 1 shown in FIG. 1. During the calcining, outside air (blowing speed: 50 L/min, outside air temperature: 25°C) was introduced from a side surface and a lower surface of the calcining furnace 2. Molybdenum trioxide was evaporated in the calcining furnace 2, then cooled in the vicinity of the collection device 4, and precipitated as particles. An RHK simulator (manufactured by NORITAKE CO., LIMITED) was used as the calcining furnace 2, and a VF-5N dust collector (manufactured by AMANO Corporation) was used as the collection device 4.

After calcining, 1.0 kg of aluminum oxide, a blue powder, and 0.85 kg of the molybdenum trioxide powder collected by the collection device 4 were taken out from the sagger. The collected molybdenum trioxide powder had an average particle diameter of primary particles of 80 nm, and by X-ray fluorescence (XRF) measurement, it was found that the purity of molybdenum trioxide was 99.7%. The specific surface area (SA) of the molybdenum trioxide powder measured by a BET method was 44.0 $m^2$/g.

Further, X-ray diffraction (XRD) of the molybdenum trioxide powder was measured. The result of an X-ray diffraction pattern is shown in FIG. 2 together with a standard pattern of an $\alpha$ crystal and a standard pattern of a $\beta$ crystal of molybdenum trioxide. A peak attributed to the $\alpha$ crystal of $MoO_3$ and a peak attributed to the $\beta$ crystal of $MoO_3$ were observed, and no other peaks were observed. Next, a peak intensity ratio ($\beta$ (011)/$\alpha$ (021)) of the plane (011) of the $\beta$ crystal (in the vicinity of $2\theta$: 23.01°, No. 86426 (inorganic crystal structure database (ICSD))) and the plane (021) of the $\alpha$ crystal (in the vicinity of $2\theta$: 27.32°, No. 166363 (inorganic crystal structure database (ICSD))) was obtained, and $\beta$ (011)/$\alpha$ (021) was 5.2.

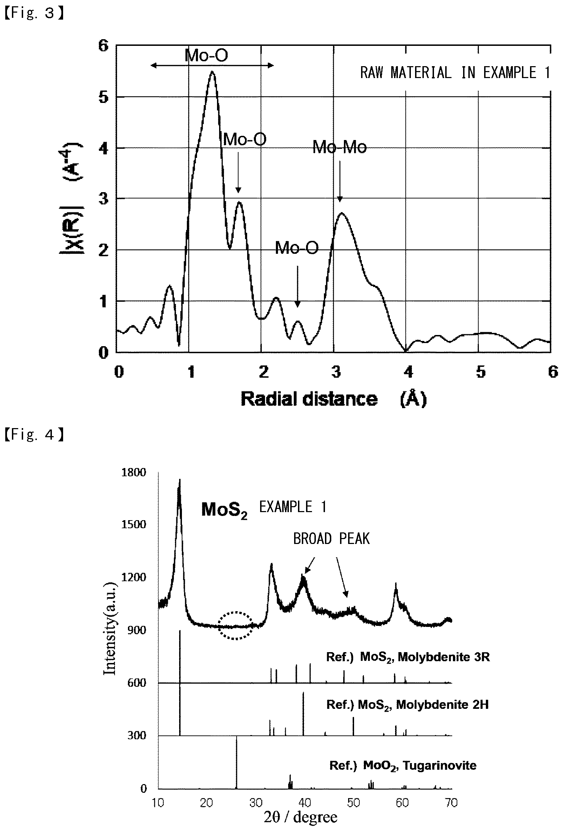

32.76 mg of the molybdenum trioxide powder and 333.0 mg of boron nitride were mixed in a mortar. 121.92 mg of the mixture was weighed and compression molded into a tablet having a diameter of 8 mm, and an extended X-ray absorption fine structure (EXAFS) was measured. FIG. 3 shows an extended X-ray absorption fine structure (EXAFS) spectrum of a K absorption edge of molybdenum. In a radial distribution function obtained from the spectrum, the ratio (I/II) of the peak intensity I caused by Mo-O to the peak intensity II caused by Mo-Mo was 2.0.

<Production of Hydrogen Generation Catalyst (Molybdenum Sulfide Powder)>

In a porcelain crucible, 1.00 g of the molybdenum trioxide powder and 1.57 g of a sulfur powder (manufactured by Kanto Chemical Co., Ltd.) were mixed with each other with a stirring rod such that the powder was uniform, and the mixture was calcined in a nitrogen atmosphere at 500°C for 4 hours to obtain a black powder. Here, the S amount in the sulfur is 705 mol% with respect to the $MoO_3$ amount of 100 mol% in the molybdenum trioxide powder. FIG. 4 shows a result of an X-ray diffraction (XRD) pattern of the black power (molybdenum sulfide powder in Example 1) together with a diffraction pattern of a 3R crystal structure of molybdenum disulfide ($MoS_2$), a diffraction pattern of a 2H crystal structure of molybdenum disulfide ($MoS_2$), and a diffraction pattern of molybdenum dioxide ($MoO_2$) which are described in the inorganic crystal structure database (ICSD). Molybdenum dioxide ($MoO_2$) is a reaction intermediate.

In the X-ray diffraction (XRD) pattern in FIG. 4, only a peak attributed to molybdenum disulfide ($MoS_2$) was detected, and a peak not attributed to molybdenum disulfide ($MoS_2$) was not observed. That is, no peaks of reaction intermediates such as molybdenum dioxide ($MoO_2$), a by-product, were observed, and only a peak attributed to molybdenum disulfide ($MoS_2$) was observed, and thus it was found that the molybdenum sulfide powder obtained above had a conversion rate $R_C$ to $MoS_2$ of 99% or more, and the reaction with sulfur proceeded rapidly.

When crystal structure analysis of the molybdenum sulfide powder in Example 1 was performed by the X-ray diffraction (XRD), it was found that a 2H crystal structure and a 3R crystal structure were included. The half widths of the peak in the vicinity of 39.5° and the peak in the vicinity of 49.5° were as wide as 2.36° and 3.71°, respectively.

The specific surface area of the molybdenum sulfide powder in Example 1 was measured by the BET method and was 70 $m^2$/g.

The particle size distribution of the molybdenum sulfide powder in Example 1 was measured by a dynamic light scattering type particle diameter distribution measuring device to obtain the median diameter $D_{50}$, which was 200 nm.

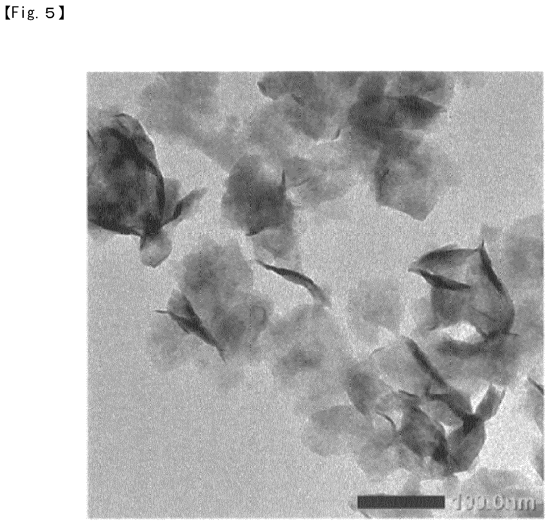

FIG. 5 shows a TEM image of the molybdenum sulfide powder in Example 1. It was observed that this powder contained a large number of sheet-shaped molybdenum sulfides.

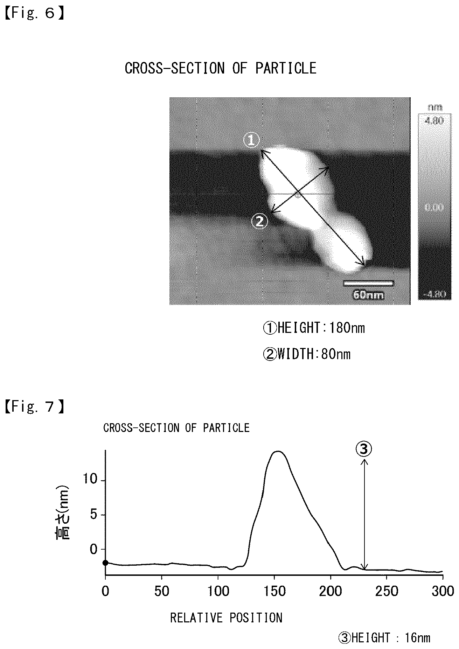

FIG. 6 shows an AFM image of the molybdenum sulfide powder in Example 1. The AFM image in FIG. 6 is obtained by measurement, and shows the upper surface of a particle of the molybdenum sulfide powder. A length (vertical) $\times$ a width (horizontal) was determined from this AFM image and was 180 nm $\times$ 80 nm. FIG. 7 shows a cross-section of the molybdenum sulfide powder shown in FIG. 6. A thickness was determined from the cross-sectional view, and was 16 nm. Therefore, a value of aspect ratio (length (vertical)/thickness) of primary particles of the molybdenum sulfide powder in Example 1 was 11.25.

<<Production of Catalyst Ink>>

A 5% Nafion (registered trademark) dispersion (DE520 CS type manufactured by FUJIFILM Wako Pure Chemical Corporation) was diluted with a mixed solvent containing ultrapure water and 1-propanol in a mass ratio of 1:1 to prepare 1 wt% Nafion (registered trademark).

2.0 mg of the molybdenum sulfide powder obtained in Example 1 was added to a mixed solution of 100 μL of 1-hexanol and 4.1 μL of 1 wt% Nafion (registered trademark), and dispersed by an ultrasonic treatment, to prepare a catalyst ink.

<<Evaluation of Hydrogen Generation Catalyst>>

<Production of Working Electrode>

10.6 μL of the dispersion liquid (catalyst ink) obtained as described above was applied to a glassy carbon rod (manufactured by Tokai Carbon Co., Ltd., 5 mm in diameter × 10 mm) as a base material for a working electrode and dried at 60°C for 1 hour, to produce a working electrode having a catalyst layer (hydrogen generation catalyst layer) containing the molybdenum sulfide powder. The amount of molybdenum sulfide supported on the glassy carbon rod was 1.0 mg/cm$^2$.

<Evaluation of Hydrogen Generation Catalyst>

Electrochemical measurement was performed at a temperature of 30°C by using a three-electrode cell manufactured by Miclab Co., Ltd., and a potentiostat manufactured by Toho Technical Research Co., Ltd., and using 0.5 M $H_2SO_4$ as an electrolytic solution. A reversible hydrogen electrode (RHE) was used as a reference electrode, and a glassy carbon plate was used as a counter electrode. As a pretreatment, cyclic voltammetry of 100 cycles was performed in a nitrogen atmosphere at a scanning speed of 100 mV/s in the range of -0.3 V to 0.5 V.

Then, low-speed scan voltammetry was separately performed in an oxygen atmosphere and a nitrogen atmosphere at a scanning speed of 5 mV/s in the range of -0.3 V to 0.5 V ($2H^+ + 2e^- => H_2$) .

The current density (mA·cm$^2$) in a hydrogen evolution reaction (HER) was calculated based on a difference between current densities in the oxygen atmosphere and the nitrogen atmosphere. The current density at an overvoltage η of 300 mV was determined and was -2.5mA/cm$^2$. The overvoltage η at a current density of 1 mA/cm$^2$ was -231.7mV.

<<Production of Hydrogen Generation Catalyst, Production of Catalyst Ink, Production of Working Electrode, and Evaluation of Hydrogen Generation Catalyst>>

[Example 2]

A hydrogen generation catalyst, a catalyst ink, and a working electrode were produced and the hydrogen generation catalyst was evaluated in the same manner as in Example 1 except that during production of the catalyst ink, 2.0 mg of the molybdenum sulfide powder obtained in Example 1 and 0.2 mg of conductive carbon black (ketjen black (registered trademark), EC300J, median diameter $D_{50}$: 40 nm) manufactured by Lion Specialty Chemicals Co., Ltd., were used. In the working electrode, the amount of molybdenum sulfide supported on the glassy carbon rod was 1.0 mg/cm$^2$. The current density at an overvoltage η of 300 mV was determined and was -16.1mA/cm$^2$. The overvoltage η at a current density of 1 mA/cm$^2$ was -126.7 mV, and the overvoltage η at a current density of 10 mA/cm$^2$ was -245.2 mV.

[Example 3]

<<Production of Hydrogen Generation Catalyst (Metal-Doped Molybdenum Sulfide Powder)>>

<Production of Metal-Doped Molybdenum Sulfide Powder (Production Method (3))>

From 5 g of the molybdenum trioxide powder obtained in Example 1 and 195 g of ion exchanged water, an aqueous dispersion of molybdenum trioxide powder with a concentration of 2.5 mass% was obtained.

From 0.18 g of cobalt chloride hexahydrate (manufactured by Kanto Chemical Co., Inc.) and 9.82 g of ion exchanged water, an aqueous solution of cobalt chloride with a concentration of 1 mass% was obtained.

20 g of the aqueous dispersion of the molybdenum trioxide powder obtained as described above, 0.9 g of the cobalt chloride aqueous solution, 19.1 g of ion exchanged water, and 0.8 g of sulfur powder (manufactured by Kanto Chemical Co., Inc.) were mixed and stirred at normal temperature for 3 hours to obtain a raw material mixture (2). In the obtained raw material mixture (2), the amount of sulfur powder blended was 7 times by mole the amount of the molybdenum trioxide powder blended, the amount of cobalt chloride hexahydrate blended is 2 mol% with respect to the amount of the molybdenum trioxide powder blended, and the amount of water blended is 80 times by mass the amount of the molybdenum trioxide powder blended.

From the raw material mixture (2) obtained, water was removed by freeze drying, to obtain a solid (2).

Subsequently, the solid (2) obtained was heated (calcined) in a porcelain crucible at 400°C for 4 hours under a nitrogen flow at a flow rate of 300 mL/min, to obtain a powder (cobalt-doped molybdenum sulfide powder).

An X-ray diffraction (XRD) pattern of this powder in Example 3 was observed. Only a peak attributed to molybdenum disulfide ($MoS_2$) was detected, and a peak not attributed to molybdenum disulfide ($MoS_2$) was not observed. That is, no peaks of reaction intermediates such as molybdenum dioxide ($MoO_2$), a by-product, were observed, and only a peak attributed to molybdenum disulfide ($MoS_2$) was observed, and thus it was found that the metal-doped molybdenum sulfide powder obtained above had a conversion rate $R_C$ to $MoS_2$ of 99% or more, and the reaction with sulfur proceeded rapidly.

When crystal structure analysis of the metal-doped molybdenum sulfide powder in Example 3 was performed by the X-ray diffraction (XRD), it was found that a 2H crystal structure and a 3R crystal structure were included.

The metal doping amount (cobalt doping amount) of the metal-doped molybdenum sulfide powder (cobalt-doped molybdenum sulfide powder) in Example 3 was determined by XRF analysis and was 0.77 mol%.

The specific surface area of the metal-doped molybdenum sulfide powder in Example 3 was measured by the BET method and was 35.6 $m^2$/g.

The ratio (I/II) in the metal-doped molybdenum sulfide powder in Example 3 was determined and was 1.704.

The particle size distribution of the metal-doped molybdenum sulfide powder in Example 3 was measured with a dynamic light scattering type particle diameter distribution measuring device to obtain the median diameter $D_{50}$, which was 810 nm.

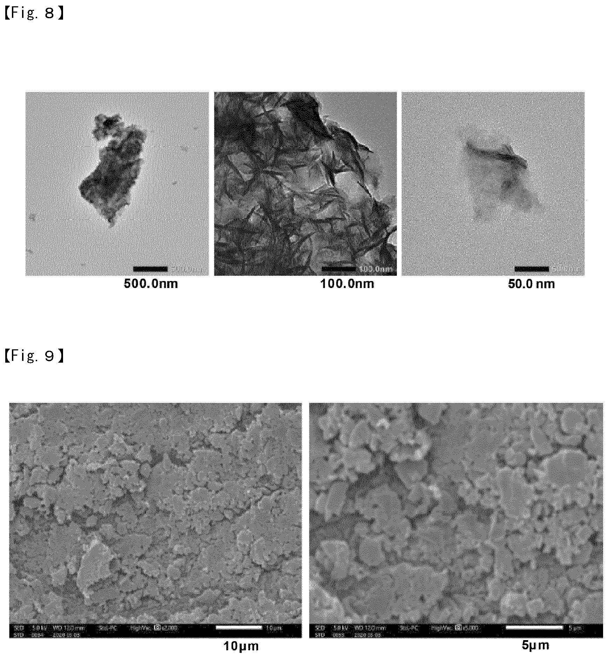

FIG. 8 shows TEM images of the metal-doped molybdenum sulfide powder in Example 3.

FIG. 9 shows SEM images of the metal-doped molybdenum sulfide powder in Example 3. In the metal-doped molybdenum sulfide powder in Example 3 of FIG. 9, an aggregate of particles having a size of several micrometers was observed.

In the same manner as Example 1, AFM images of the metal-doped molybdenum sulfide powder in Example 3 were obtained, a length (vertical) × a width (horizontal) was determined from these AFM images and was 500 nm × 400 nm, and the thickness was 13 nm. Therefore, a value of aspect ratio (length (vertical)/thickness) of primary particles of the metal-doped molybdenum sulfide powder in Example 3 was 38.46.

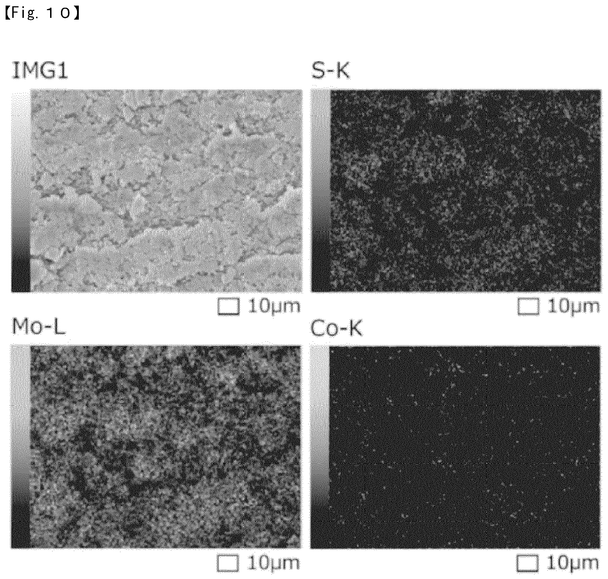

FIG. 10 shows EDS images of the metal-doped molybdenum sulfide powder in Example 3. From FIG. 10, uniform distribution of cobalt (in FIG. 10, represented by "Co-K"), molybdenum (in FIG. 10, represented by "Mo-L"), and sulfur (in FIG. 10, represented by "S-K") was confirmed in the whole of the metal-doped molybdenum sulfide powder in Example 3.

From various analysis results including the X-ray diffraction pattern and the EDS images, it was found that a target metal-doped molybdenum sulfide powder was surely obtained.

<<Production of Catalyst Ink, and Evaluation of Hydrogen Generation Catalyst>>

A catalyst ink was produced and a hydrogen generation catalyst was evaluated in the same manner as in Example 1 except that during production of the catalyst ink, 2.0 mg of the metal-doped molybdenum sulfide powder obtained in Example 3 was used instead of 2.0 mg of the molybdenum sulfide powder obtained in Example 1. In the working electrode, the amount of metal-doped molybdenum sulfide supported on the glassy carbon rod was 1.0 mg/$cm^2$. The current density at an overvoltage η of 300 mV was determined and was -6.4 mA/$cm^2$. The overvoltage η at a current density of 1 mA/$cm^2$ was -170.0 mV.

[Comparative Example 1]

Electrochemical measurement was carried out in the same manner as in Example 1 except that a catalyst ink was not used. The current density at an overvoltage η of 300 mV was determined and was -0.2 mA/$cm^2$.

[Comparative Example 2]

A catalyst ink for comparison was produced and a hydrogen generation catalyst for comparison (molybdenum sulfide powder) was evaluated in the same manner as in Example 1 except that during production of the catalyst ink, 2.0 mg of molybdenum sulfide powder manufactured by Kanto Chemical Co., Inc., was used instead of 2.0 mg of the molybdenum sulfide powder obtained in Example 1.

The specific surface area of the molybdenum sulfide powder for comparison was measured by the BET method and was 3.0 m$^2$/g.

The particle size distribution of the molybdenum sulfide powder for comparison was measured by a dynamic light scattering type particle diameter distribution measuring device to obtain the median diameter D$_{50}$, which was 30 μm or less.

In the working electrode, the amount of molybdenum sulfide supported on the glassy carbon rod was 1.0 mg/cm$^2$. The current density at an overvoltage η of 300 mV was determined and was -0.3mA/cm$^2$.

[Table 1]

| | Type of hydrogen generation catalyst | Physical properties of powder | | Amount of MoS$_2$ supported (mg/cm$^2$) |
|---|---|---|---|---|
| | | Specific surface area (m$^2$/g) | Median diameter D$_{50}$ (nm) | |
| Example 1 | Molybdenum sulfide powder containing MoS$_2$ having 2H crystal structure and 3R crystal structure | 70 | 200 | 1.0 |
| Example 2 | Molybdenum sulfide powder containing MoS$_2$ having 2H crystal structure | 70 | 200 | 1.0 |
| | and 3R crystal structure + carbon black | | | |
| Example 3 | Co-doped molybdenum sulfide powder containing MoS$_2$ having 2H crystal structure and 3R crystal structure | 35.6 | 810 | 1.0 |
| Comparative Example 1 | - | - | - | 0 |
| Comparative Example 2 | MoS$_2$ having 2H crystal structure and no 3R crystal structure | 3.0 | ≤30000 | 1.0 |

[Table 2]

| | Result of evaluation of hydrogen generation catalyst | | |
|---|---|---|---|
| | Current density (mA/cm$^2$) at overvoltage η of 300 mV | Overvoltage η (mV) at current density of 10 mA/cm$^2$ | Overvoltage η (mV) at current density of 1 mA/cm$^2$ |
| Example 1 | -2.5 | - | -231.7 |
| Example 2 | -16.1 | -245.2 | -126.7 |
| Example 3 | -6.4 | - | -170.0 |
| Comparative Example 1 | -0.2 | - | - |
| Comparative Example 2 | -0.3 | - | - |

From the results in Examples and Comparative Examples, it was confirmed that the molybdenum sulfide powder and the metal-doped molybdenum sulfide powder having 2H crystal structure and a 3R crystal structure exhibited a higher activity than that of a molybdenum sulfide powder having no 3R crystal structure as the hydrogen generation catalyst.

Industrial Applicability

The present invention is available as a catalyst for a hydrogen evolution reaction.

Reference Signs List

1: Production apparatus
2: Calcining furnace
3: Cooling pipe
4: Collection device
5: Discharge port
6: Opening degree adjustment damper
7: Observation window
8: Air exhauster
9: External cooling device

**Claims**

1. A hydrogen generation catalyst comprising: a molybdenum sulfide powder containing molybdenum disulfide having a 3R crystal structure.

2. The hydrogen generation catalyst according to claim 1, wherein the molybdenum sulfide powder contains molybdenum disulfide having a 2H crystal structure and a 3R crystal structure.

3. The hydrogen generation catalyst according to claim 2, wherein in a spectrum of the molybdenum sulfide powder obtained by powder X-ray diffraction (XRD) using Cu-Kα rays as an X-ray source, both a peak in the vicinity of 39.5° and a peak in the vicinity of 49.5° include a synthetic peak of the 2H crystal structure and the 3R crystal structure, and a half width is 1° or more.

4. The hydrogen generation catalyst according to any one of claims 1 to 3, wherein primary particles of molybdenum disulfide particles constituting the molybdenum sulfide powder have a string shape, a ribbon shape, or a sheet shape, and have a thickness within a range of 1 nm to 40 nm.

5. The hydrogen generation catalyst according to any one of claims 1 to 4, wherein the molybdenum sulfide powder has a specific surface area of 10 $m^2$/g or more measured by a BET method.

6. The hydrogen generation catalyst according to any one of claims 1 to 5, wherein the molybdenum sulfide powder has a median diameter $D_{50}$ of 10 nm to 2,000 nm obtained by a dynamic light scattering type particle diameter distribution measuring device.

7. The hydrogen generation catalyst according to any one of claims 1 to 6, wherein in a radial distribution function of the molybdenum sulfide powder obtained from an extended X-ray absorption fine structure (EXAFS) spectrum of a K absorption edge of molybdenum, a ratio (I/II) of peak intensity I caused by Mo-S to peak intensity II caused by Mo-Mo is more than 1.0.

8. A hydrogen generation catalyst comprising: a metal-doped molybdenum sulfide powder containing a doping metal in Groups 3 to 13 and molybdenum disulfide having a 3R crystal structure.

9. The hydrogen generation catalyst according to claim 8, wherein the metal-doped molybdenum sulfide powder contains molybdenum disulfide having a 2H crystal structure and a 3R crystal structure.

10. The hydrogen generation catalyst according to claim 9, wherein in a spectrum of the metal-doped molybdenum sulfide powder obtained by powder X-ray diffraction (XRD) using Cu-Kα rays as an X-ray source, both a peak in the vicinity of 39.5° and a peak in the vicinity of 49.5° include a synthetic peak of the 2H crystal structure and the 3R crystal structure, and a half width is 1° or more.

11. The hydrogen generation catalyst according to any one of claims 8 to 10, wherein primary particles of molybdenum disulfide particles constituting the metal-doped molybdenum sulfide powder have a string shape, a ribbon shape, or a sheet shape, and have a thickness within a range of 1 nm to 40 nm.

12. The hydrogen generation catalyst according to any one of claims 8 to 11, wherein the metal-doped molybdenum sulfide powder has a specific surface area of 10 m$^2$/g or more measured by a BET method.

13. The hydrogen generation catalyst according to any one of claims 8 to 12, wherein the metal-doped molybdenum sulfide powder has a median diameter $D_{50}$ of 10 nm to 2,000 nm obtained by a dynamic light scattering type particle diameter distribution measuring device.

14. The hydrogen generation catalyst according to any one of claims 8 to 13, wherein in a radial distribution function of the metal-doped molybdenum sulfide powder obtained from an extended X-ray absorption fine structure (EXAFS) spectrum of a K absorption edge of molybdenum, a ratio (I/II) of peak intensity I caused by Mo-S to peak intensity II caused by Mo-Mo is more than 1.0.

15. The hydrogen generation catalyst according to any one of claims 8 to 14, wherein the metal in Groups 3 to 13 is one or two or more selected from the group consisting of cobalt, palladium, iridium, manganese, iron, nickel, zirconium, ruthenium, indium, and zinc.

16. The hydrogen generation catalyst according to any one of claims 1 to 15, further comprising a conductive material.

17. A catalyst ink comprising:

   the hydrogen generation catalyst according to any one of claims 1 to 16; and
   a solvent.

【Fig. 1】

【Fig. 2】

【Fig. 3】

【Fig. 4】

【Fig. 5】

【Fig. 6】

CROSS-SECTION OF PARTICLE

①HEIGHT：180nm

②WIDTH：80nm

【Fig. 7】

CROSS-SECTION OF PARTICLE

③HEIGHT：16nm

【Fig. 8】

500.0nm          100.0nm          50.0 nm

【Fig. 9】

10μm                          5μm

【Fig. 1 0】

IMG1

S-K

Mo-L

Co-K

## INTERNATIONAL SEARCH REPORT

| International application No. |
| --- |
| **PCT/JP2022/004028** |

**A. CLASSIFICATION OF SUBJECT MATTER**

*B01J 27/051*(2006.01)i; *B01J 27/049*(2006.01)i; *B01J 37/20*(2006.01)i; *C01B 3/04*(2006.01)i; *C25B 11/075*(2021.01)i; *C25B 11/091*(2021.01)i; *C30B 29/48*(2006.01)i; *H01M 8/0656*(2016.01)i

FI: B01J27/051 M; B01J27/049 M; B01J37/20; C30B29/48; H01M8/0656; C25B11/075; C25B11/091; C01B3/04 R

According to International Patent Classification (IPC) or to both national classification and IPC

**B. FIELDS SEARCHED**

Minimum documentation searched (classification system followed by classification symbols)

B01J21/00-38/74; C01B3/02-6/34; C25B11/00-11/18; H01M8/04-8/0668

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

Scopus; JSTPlus (JDreamIII); JST7580 (JDreamIII); JSTChina (JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2019/181723 A1 (DAINIPPON INK & CHEMICALS) 26 September 2019 (2019-09-26) paragraphs [0018]-[0020], [0049], [0053], [0057]-[0074], fig. 3-4 | 1-17 |
| X | TOH, Rou Jun et al. 3R phase of MoS2 and WS2 outperforms the corresponding 2H phase for hydrogen evolution. Chem. Commun. 27 February 2017, vol. 53, no. 21, pp. 3054-3057, S1-S13, DOI: 10.1039/c6cc09952a p. 3055, left column, line 18 to p. 3057, right column, line 3, p. S2, Hydrogen Evolution Reaction, p. S3, fig. S1-S2, p. S7, table S1 | 1-4, 8-11, 15-17 |
| A | JP 2019-524433 A (UNIV BEIJING) 05 September 2019 (2019-09-05) entire text | 1-17 |
| A | JP 2020-070450 A (JIKU KAGAKU KK) 07 May 2020 (2020-05-07) entire text | 1-17 |
| P, X | WO 2021/144810 A1 (COUNCIL OF SCIENTIFIC AND INDUSTRIAL RESEARCH) 22 July 2021 (2021-07-22) examples, fig. 1 | 1, 2, 8, 9, 15-17 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **22 March 2022** | **05 April 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
**Information on patent family members**

International application No.

**PCT/JP2022/004028**

| Patent document cited in search report | | | Publication date (day/month/year) | Patent family member(s) | | | Publication date (day/month/year) |
|---|---|---|---|---|---|---|---|
| WO | 2019/181723 | A1 | 26 September 2019 | US | 2021/0053037 | A1 | |
| | | | | paragraphs [0031]-[0033], [0066], [0071], [0075]-[0092], fig. 3-4 | | | |
| | | | | EP | 3770120 | A1 | |
| | | | | CN | 111886203 | A | |
| | | | | KR | 10-2020-0130807 | A | |
| | | | | TW | 201945287 | A | |
| JP | 2019-524433 | A | 05 September 2019 | US | 2019/0267620 | A1 | |
| | | | | the whole document | | | |
| | | | | WO | 2018/019231 | A1 | |
| | | | | EP | 3502318 | A1 | |
| | | | | CN | 106960948 | A | |
| JP | 2020-070450 | A | 07 May 2020 | (Family: none) | | | |
| WO | 2021/144810 | A1 | 22 July 2021 | (Family: none) | | | |

Form PCT/ISA/210 (patent family annex) (January 2015)

**REFERENCES CITED IN THE DESCRIPTION**

**Patent documents cited in the description**

- JP 2021019047 A
- JP 2004277199 A

- JP 2004512250 T

**Non-patent literature cited in the description**

- *Chem. Rev.,* 2016, vol. 1, 699-726